(19) Europäisches Patentamt
European Patent Office
Office européen des brevets

(11) **EP 4 458 175 A1**

(12) **EUROPEAN PATENT APPLICATION**
published in accordance with Art. 153(4) EPC

(43) Date of publication:
**06.11.2024 Bulletin 2024/45**

(21) Application number: **22915943.9**

(22) Date of filing: **23.12.2022**

(51) International Patent Classification (IPC):
**A24F 40/20** (2020.01)    **A24F 40/40** (2020.01)
**A24F 40/50** (2020.01)

(52) Cooperative Patent Classification (CPC):
**A24F 40/20; A24F 40/40; A24F 40/50**

(86) International application number:
**PCT/JP2022/047579**

(87) International publication number:
**WO 2023/127720 (06.07.2023 Gazette 2023/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.12.2021 JP 2021214320**

(71) Applicant: **Japan Tobacco Inc.
Tokyo 105-6927 (JP)**

(72) Inventors:
• INOUE, Jumpei
  Tokyo 130-8603 (JP)
• ABE, Yuki
  Tokyo 130-8603 (JP)
• TAKEUCHI, Manabu
  Tokyo 130-8603 (JP)

(74) Representative: **Hoffmann Eitle
Patent- und Rechtsanwälte PartmbB
Arabellastraße 30
81925 München (DE)**

(54) **NON-COMBUSTION FLAVOR INHALER**

(57)    A non-combustion flavor inhaler (30) comprises: an accommodation part (310) that accommodates a flavor stick (100) such that the flavor stick can be inserted into and ejected from the accommodation part, the flavor stick having a flavor rod portion (110) and a mouthpiece portion (120); a heating part (32) that heats the flavor stick; a control part (37) that controls electrical power supplied to the heating part to control heating by the heating part; and electrostatic capacitance sensors (301, 302, 305, 306) that detect electrostatic capacitance changing according to the condition of the flavor stick accommodated in the accommodation part. The control part controls the electrical power supplied to the heating part on the basis of a first detected value detected by the electrostatic capacitance sensors at first timing after insertion of the flavor stick and second detected value detected at second timing after the first timing. Provided thereby is a technology for suitably controlling heating according to the condition of the flavor stick.

FIG. 1

**Description**

Technical Field

The present invention relates to a non-combustion-type flavor inhaler.

Background Art

A non-combustion-type flavor inhaling system is suggested as an alternative to an existing combustion-type tobacco that is smoked by burning tobacco leaves. For example, a non-combustion-heating-type tobacco product is known. The non-combustion-heating-type tobacco product includes an electric heating device and a tobacco stick. The electric heating device includes a heater assembly, a battery unit that serves as an electric power supply of the heater assembly, a controller that controls a heating element of the heater assembly, and the like. The tobacco stick is used together with the electric heating device.

There is also known a mechanism that, in an inhaler that heats a tobacco stick inserted in a non-combustion-type flavor inhaler by a user, detects insertion of the tobacco stick based on a change in capacitance (PTL 1). There is also known a mechanism that provides a marker on a stick side and detects insertion of the tobacco stick or the type of the tobacco stick by measuring a capacitance associated with the marker (PTL 2).

Citation List

Patent Literature

PTL 1: Japanese Unexamined Patent Application Publication (Translation of PCT Application) No. 2017-510270
Non Patent Literature

PTL 2: International Publication No. 2019/185748

Summary of Invention

Technical Problem

In a non-combustion-type flavor inhaler, appropriate heating of a flavor stick (hereinafter, also referred to as tobacco stick) is desired. Ordinarily, a heating time and a heating temperature are set in advance, and heating is controlled. However, the state of a flavor stick varies depending on a smoking situation of a user, a state of preservation of the flavor stick, and the like, so appropriate heating control also varies.

An object of the present invention is contemplated in view of the above-described situation and is to provide a technology for appropriately executing heating control according to a state of a flavor stick.

Solution to Problem

The technology according to the present invention is
a non-combustion-type flavor inhaler including:

a container that accommodates a flavor stick having a flavor rod portion and an inhalation port so that the flavor stick can be inserted and removed;
a controller that controls heating with the heater by controlling electric power supplied to a heater for heating the flavor stick; and
a capacitance sensor that detects a capacitance that changes depending on a state of the flavor stick accommodated in the container, wherein
the controller controls electric power supplied to the heater based on a first detection value detected by the capacitance sensor at first timing after insertion of the flavor stick and a second detection value detected at second timing after the first timing.

In the non-combustion-type flavor inhaler, the controller may end heating when a difference between the first detection value and the second detection value is greater than or equal to a first predetermined value.

In the non-combustion-type flavor inhaler, the controller may change electric power supplied to the heater when a difference between the first detection value and the second detection value is greater than or equal to a second predetermined value.

In the non-combustion-type flavor inhaler,

the controller may

end heating when a difference between the first detection value and the second detection value is greater than or equal to a first predetermined value, and

change electric power supplied to the heater when a difference between the first detection value and the second detection value is greater than or equal to a second predetermined value lower than the first predetermined value.

In the non-combustion-type flavor inhaler, the first timing may be timing determined to a period from just after insertion of the flavor stick to just before start of heating.

The non-combustion-type flavor inhaler may further include an inhalation sensor that detects that inhalation of the flavor stick is performed, wherein

the controller may set the second timing to timing to perform detection with the capacitance sensor in a period in which inhalation is not being performed, based on a detection result of the inhalation sensor.

In the non-combustion-type flavor inhaler, the capacitance sensor may have a first electrode and a second electrode disposed at a distance from each other and detect a capacitance between the first electrode and the second electrode, and

the first electrode and the second electrode may be disposed across a space in which the flavor rod portion is accommodated such that, when the flavor stick is accommodated in the container, at least part of the flavor rod portion is inserted between the first electrode and the second electrode.

In the non-combustion-type flavor inhaler, the capacitance sensor may have a first electrode and a second electrode disposed at a distance from each other and detect a capacitance between the first electrode and the second electrode, and

the first electrode and the second electrode may be disposed across a space in which the inhalation port is accommodated such that, when the flavor stick is accommodated in the container, at least part of the inhalation port is inserted between the first electrode and the second electrode.

Means for solving the problem according to the present invention may adopt combinations as much as possible.
Advantageous Effects of Invention

According to the present invention, it is possible to provide a technology for appropriately executing heating control according to a state of the flavor stick.

Brief Description of Drawings

Fig. 1 is a schematic configuration diagram of a non-combustion-type flavor inhaling system according to a first embodiment.
Fig. 2 is a perspective view of a tobacco stick according to the first embodiment.
Fig. 3 is a view illustrating the internal structure of the tobacco stick according to the first embodiment.
Fig. 4 is view schematically showing the internal structure of a non-combustion-type flavor inhaler according to the first embodiment.
Fig. 5 is a view showing an example in which planer first to fourth electrodes are disposed.
Fig . 6 is a view showing an example in which curved first to fourth electrodes are disposed.
Fig. 7 is a view showing an example of a capacitance sensor formed on a flexible circuit board.
Fig. 8 is a view showing an example in which the first to second electrodes are provided on an inner periphery of a circumferential wall.
Fig. 9 is a view showing an example in which the first to second electrodes are embedded in the circumferential wall.
Fig. 10 is a diagram showing the configuration of a controller.
Fig. 11 is a graph showing results obtained by measuring a capacitance between the electrodes of the capacitance sensors in a case where a tobacco stick is not inserted and in a case where positions of the electrodes with respect to the tobacco stick are varied.
Fig. 12 is a view showing a positional relationship between the tobacco stick and the electrodes when measurement of Fig. 11 is performed.
Fig. 13 is a graph showing results obtained by detecting a capacitance while the sizes of the electrodes are varied.
Fig. 14 is a graph showing a change in capacitance due to a puff.

Fig. 15 is a graph showing a change in capacitance in a case where the hand of a user is touching a tobacco stick and in a case where the hand is not touching a tobacco stick.

Fig. 16 is a graph showing a temporal change in capacitance at the time of inserting and removing a tobacco stick.

Fig. 17 is a graph showing a temporal change in capacitance at the time of putting a mouth at a mouthpiece portion to inhale and separating the mouth from the mouthpiece portion to blow out a breath.

Fig. 18A is a flowchart showing a control method that a controller executes.

Fig. 18B is a flowchart showing the control method that the controller executes.

Fig. 19A is a schematic configuration diagram of a non-combustion-type flavor inhaler according to a third embodiment.

Fig. 19B is a sectional view taken along the line C-C in Fig. 19.

Fig. 20A is a schematic configuration diagram of a non-combustion-type flavor inhaler according to the third embodiment.

Fig. 20B is a sectional view taken along the line A-A in Fig. 19.

Fig. 21 is a view showing an example in which electrodes are provided on an outer peripheral side of a heater.

Fig. 22 is a view showing an example in which electrodes are respectively fitted to gaps of the heater.

Fig. 23 is a view showing an example in which an installation location of a cylindrical heater is offset to a front side in an axial direction of a container.

Fig. 24 is a schematic configuration diagram of a non-combustion-type flavor inhaler according to a fourth embodiment.

Fig. 25 is a perspective view of an induction coil.

Fig. 26 is a schematic configuration diagram of a non-combustion-type flavor inhaler according to a fifth embodiment.

Fig. 27 is a sectional view taken along the line B-B in Fig. 26.

Fig. 28 is a view showing an example in which electrodes are provided on an outer peripheral side of a heat generator

Fig. 29 is a view showing an example in which electrodes are respectively fitted to gaps of the heat generator

Fig. 30 is a view showing an example in which an installation location of a cylindrical heat generator is offset to a front side in an axial direction of a container.

Fig. 31 is a schematic configuration diagram of a non-combustion-type flavor inhaler according to a sixth embodiment.

Description of Embodiments

Embodiments of the flavor stick and the non-combustion-type flavor inhaling system according to the present invention will be described with reference to the drawings. Sizes, materials, shapes, relative positions, and the like of structural elements described in the present embodiments are one examples. For example, in the present embodiments, a flavor stick (hereinafter, also referred to as "tobacco stick") including a tobacco filler as a flavor source will be described as an example of the flavor stick. A flavor stick may contain another flavor component without containing a tobacco filler.

<First Embodiment>

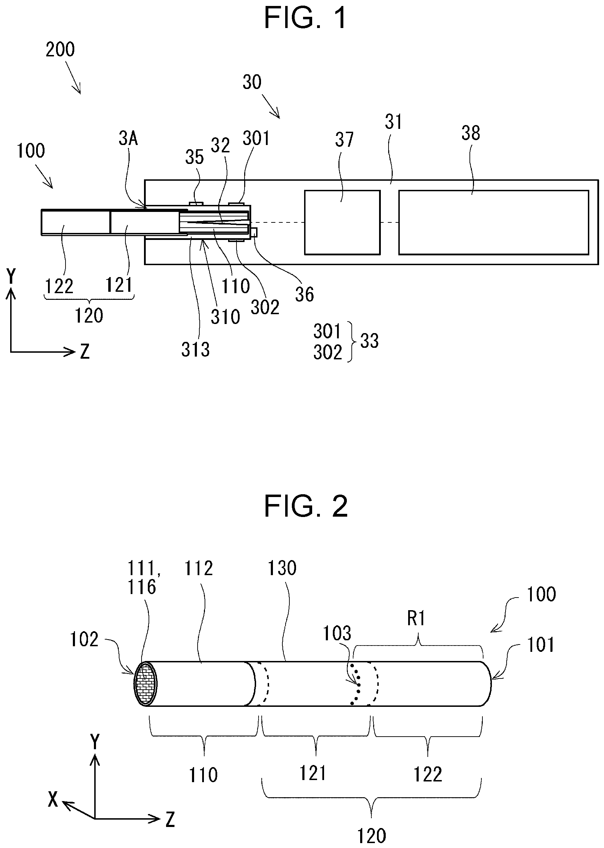

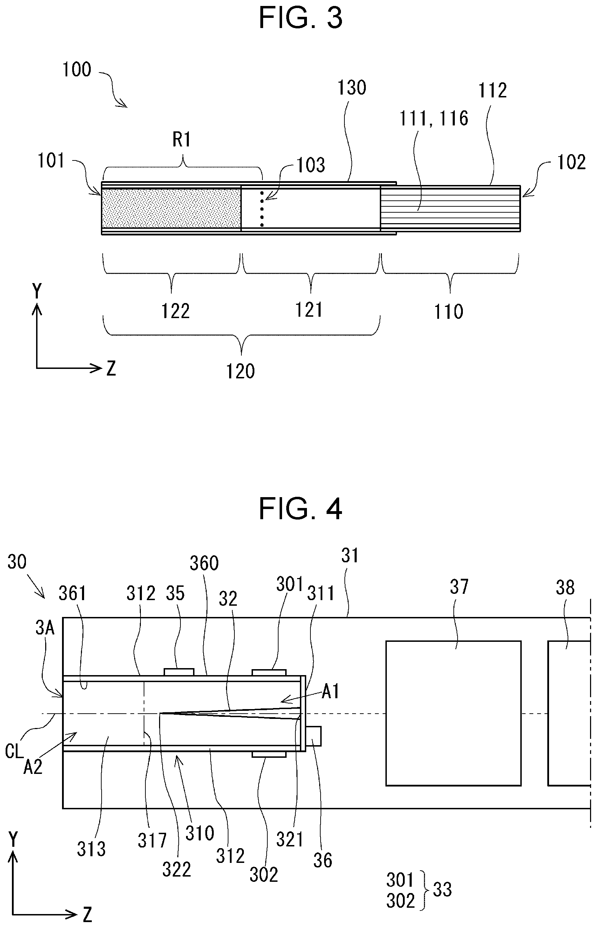

Fig. 1 is a schematic configuration diagram of a non-combustion-type flavor inhaling system 200 according to the embodiment. Fig. 2 is a perspective view of a tobacco stick 100 according to the embodiment. Fig. 3 is a view illustrating the internal structure of the tobacco stick 100 according to the embodiment. In Figs. 1 to 3, a right and left direction, an up and down direction, and a depth direction of the tobacco stick 100 or a non-combustion-type flavor inhaler 30 to which the tobacco stick 100 is inserted are respectively indicated as an X direction, a Y direction, and a Z direction. The same applies to the subsequent drawings. These directions are just illustrated for the sake of convenience of description and do not limit elements of the non-combustion-type flavor inhaling system 200. For example, the elements of the non-combustion-type flavor inhaling system 200 are not limited to arrangement of orientations shown in the drawings.

The non-combustion-type flavor inhaling system 200 includes the tobacco stick 100, and the non-combustion-type flavor inhaler 30 that heats a tobacco rod portion (flavor rod portion) 110 of the tobacco stick 100. The tobacco stick 100 is accommodated in a container cavity 313 of a container 310 through an insertion port 3A of the non-combustion-type flavor inhaler 30 so as to be freely inserted and removed.

When the non-combustion-type flavor inhaler 30 is used by a user, the tobacco stick 100 is inserted in the container cavity 313. In this state, when the non-combustion-type flavor inhaler 30 causes a heater 32 in the container 310 to generate heat to heat a tobacco filler in the tobacco stick 100, the non-combustion-type flavor inhaler 30 generates an aerosol containing a tobacco component to be made available for inhalation of the user.

[Tobacco Stick]

The tobacco stick 100 according to the present embodiment has a substantially cylindrical rod form. In the example shown in Figs. 2 and 3, the tobacco stick 100 includes the tobacco rod portion 110, a mouthpiece portion (inhalation port) 120, and tipping paper 130 uniting them as one. The mouthpiece portion 120 is coaxially coupled to the tobacco rod portion 110 when wrapped with the tipping paper 130 together with the tobacco rod portion 110.

Reference sign 101 indicates a mouthpiece end of the tobacco stick 100 (mouthpiece portion 120). Reference sign 102 indicates a distal end of the tobacco stick 100 on an opposite side to the mouthpiece end 101. The tobacco rod portion 110 is disposed adjacent to the distal end 102 side in the tobacco stick 100. In the example shown in Figs. 2 and 3, the tobacco stick 100 has a substantially constant diameter over the entire length in a longitudinal direction (hereinafter, also referred to as an axial direction or the Z direction) from the mouthpiece end 101 to the distal end 102.

[Tipping Paper]

The material of the tipping paper 130 is not limited. The material may be a paper made of general botanical fibers (pulp), a sheet using chemical fibers of polymers (polypropylene, polyethylene, nylon, or the like), a sheet of polymers, a metal foil, or the like, or a composite material combining some of them. For example, the tipping paper 130 may be made of a composite material obtained by laminating a polymer sheet to a paper substrate. Here, the tipping paper 130 means a sheet material connecting a plurality of segments in the tobacco stick 100, for example, coupling the tobacco rod portion 110 to the mouthpiece portion 120.

The basis weight of the tipping paper 130 is not limited. The basis weight is commonly greater than or equal to 32 gsm and less than or equal to 40 gsm, preferably greater than or equal to 33 gsm and less than or equal to 39 gsm, and more preferably greater than or equal to 34 gsm and less than or equal to 38 gsm. The air permeability of the tipping paper 130 is not limited. The air permeability is commonly higher than or equal to 0 CORESTA Unit and lower than or equal to 30000 CORESTA Unit, and preferably higher than 0 CORESTA Unit and lower than or equal to 10000 CORESTA Unit. Air permeability is a value measured in compliant with ISO2965: 2009, and indicates the flow rate ($cm^3$) of gas that passes through an area 1 $cm^2$ per one minute when the pressure difference between both sides is 1 kPa. One CORESTA Unit (1 C.U.) is $cm^3/(mim \cdot cm^2)$ under 1 kPa.

The tipping paper 130 may contain a filler in addition to the above-described pulp. Examples of the filler include a metal carbonate, such as calcium carbonate and magnesium carbonate, a metal oxide, such as titanium oxide, titanium dioxide, and aluminum oxide, a metal sulfate, such as barium sulfate and calcium sulfate, a metal sulfide, such as zinc sulfide, quartz, kaolin, talc, diatom earth, and gypsum. Particularly, the tipping paper 130 preferably contains calcium carbonate from the viewpoint of improving whiteness and opacity and increasing a heating rate. One of these fillers may be used solely or two or more of these fillers may be used in combination.

The tipping paper 130 may be added with various aids in addition to the above-described pulp and/or fillers and may have, for example, a water resistance improving agent for improvement in water resistance. The water resistance improving agent includes a wet strength agent (WS agent) and a sizing agent. Examples of the wet strength agent include urea formaldehyde resin, melamine-formaldehyde resin, and polyamide-epichlorohydrin (PAE). Examples of the sizing agent include rosin soap, alkyl ketene dimer (AKD), alkenyl succinic anhydride (ASA), and high-saponification polyvinyl alcohol with a saponification degree of higher than or equal to 90%.

A coating agent may be added to at least one side of the two front and back sides of the tipping paper 130. The coating agent is not limited and is preferably a coating agent capable of forming a film on the surface of paper and reducing liquid permeability.

A manufacturing method for the tipping paper 130 is not limited. A general method may be applied. The manufacturing method may be, for example, in the case of a mode containing pulp as a main component, a method of uniforming formation in a paper-making process with a Fourdrinier paper machine, a cylinder paper machine, a cylinder-tanmo complex paper machine, or the like using pulp. Where necessary, a wet strength agent may be added to impart a wrapping paper with water resistance or a sizing agent may be added to adjust the printing condition of the wrapping paper

<Tobacco Rod Portion>

The configuration of the tobacco rod portion 110 is not limited and may be a general mode. For example, the one in which a tobacco filler 111 is wrapped with wrapping paper 112 may be used.

[Tobacco Filler]

In the present embodiment, the tobacco filler 111 is configured to contain shredded tobacco. The material of shredded tobacco contained in the tobacco filler 111 is not limited and may be a known one, such as lamina and a leaf midrib. Alternatively, the material of shredded tobacco may be the one obtained by grinding dried tobacco leaves into ground tobacco with an average particle diameter greater than or equal to 20 $\mu$m and less than or equal to 200 $\mu$m, forming a sheet from the uniformed ground tobacco (hereinafter, also simply referred to as uniform sheet), and then shredding the uniform sheet. Alternatively, the material of shredded tobacco may be a so-called strand type in which the one obtained by shredding a uniform sheet, having a length equivalent to that of a tobacco rod in the longitudinal direction, substantially horizontally to the longitudinal direction of the tobacco rod is filled into the tobacco rod. The width of shredded tobacco is preferably greater than or equal to 0.5 mm and less than or equal to 2.0 mm for the purpose of being filled into the tobacco rod portion 110. The content of dried tobacco leaves contained in the tobacco rod portion 110 is not limited. The content of the dried tobacco leaves may be greater than or equal to 200 mg/rod portion and less than or equal to 800 mg/rod portion and preferably greater than or equal to 250 mg/rod portion and less than or equal to 600 mg/rod portion. This range is particularly suitable for the tobacco rod portion 110 with a circumference of 22 mm and a length of 20 mm.

As for tobacco leaves used to manufacture the shredded tobacco or the uniform sheet, various types of tobacco may be used. Examples of the types of tobacco include a flue cured type, a burley type, an orient type, a local type, other nicotiana-tabacum-series species, nicotiana-rustica-series species, and mixtures of them. The mixtures may be used by appropriately blending the above-described species to attain an intended taste. The details of the species of the tobaccos are disclosed in "Tobacco Dictionary, Tobacco Research Center, 2009.3.31". There is a plurality of existing methods for the method of manufacturing a uniform sheet, that is, a method of grinding tobacco leaves and working the ground tobacco leaves into a uniform sheet. The first one is a method of manufacturing a paper-made sheet by using a paper-making process. The second one is a method of casting a uniformed product onto a metal plate or a metal plate belt with a thin thickness after an appropriate solvent, such as water, is mixed with the ground tobacco leaves to be uniformed and drying the uniformed product to form a cast sheet. The third one is a method of manufacturing a calendared sheet by extruding a product obtained by mixing an appropriate solvent, such as water, with the ground tobacco leaves and uniformed, into a sheet. The type of the uniform sheet is disclosed in detail in "Tobacco Dictionary, Tobacco Research Center, 2009.3.31".

The moisture content of the tobacco filler 111 may be higher than or equal to 10wt% and lower than or equal to 15wt% with respect to the total amount of the tobacco filler 111 and preferably higher than or equal to 11wt% and lower than or equal to 13wt%. With such a moisture content, occurrence of wrapping stains is reduced, and machinability in manufacturing the tobacco rod portion 110 is improved. The size of shredded tobacco contained in the tobacco filler 111 and its preparation method are not limited. For example, the dried tobacco leaves may be the one shredded into a width greater than or equal to 0.5 mm and less than or equal to 2.0 mm. When a ground product of uniform sheet is used, dried tobacco leaves are ground into an average particle diameter of about 20 $\mu$m to about 200 $\mu$m, a sheet is formed from the uniformed ground product, and the one obtained by shredding the sheet into a width of greater than or equal to 0.5 mm and less than or equal to 2.0 mm may be used.

The tobacco filler 111 may contain an aerosol-source material that generates aerosol smoke. The type of the aerosol-source material is not limited. Extracted substances from various natural products and/or components of them may be selected according to an application. Examples of the aerosol-source material include glycerine, propylene glycol, triacetin, 1,3-butanediol, and mixtures of them. The content of the aerosol-source material in the tobacco filler 111 is not limited. From the viewpoint of sufficiently generating an aerosol and imparting a good flavor, the content of the aerosol-source material is commonly higher than or equal to 5wt% and preferably higher than or equal to 10wt% with respect to the total amount of the tobacco filler, and may be commonly lower than or equal to 50wt% and preferably higher than or equal to 15wt% and lower than or equal to 25wt%.

The tobacco filler 111 may contain a flavoring agent. The type of the flavoring agent is not limited. From the viewpoint of imparting a good flavor, examples of the type of the flavoring agent include acetanisole, acetophenone, acetyl pyrazine, 2-acetyl thiazole, alfalfa extract, amyl alcohol, amyl butyrate, trans-anethole, star anise oil, apple juice, Peru balsam oil, beeswax absolute, benzaldehyde, benzoin resinoid, benzyl alcohol, benzyl benzoate, benzyl phenyl acetate, benzyl propionate, 2,3-butanedione, 2-butanol, butyl butyrate, butyric acid, caramel, cardamom oil, carob absolute, $\beta$-carotene, carrot juice, L-carvone, $\beta$-caryophyllene, cassia bark oil, cedar wood oil, celery seed oil, chamomile oil, cinnamaldehyde, cinnamic acid, cinnamyl alcohol, cinnamyl cinnamate, citronella oil, DL-citronellol, clary sage extract, cocoa, coffee, cognac oil, coriander oil, cuminaldehyde, davana oil, $\delta$-decalactone, $\gamma$-decalactone, decanoic acid, dill herb oil, 3,4-dimethyl-1,2-cyclopentanedione, 4,5-dimethyl-3-hydroxy-2,5-dihydrofuran-2-one, 3,7-dimethyl-6-octenoic acid, 2,3-dimethyl pyrazine, 2,5-dimethyl pyrazine, 2,6-dimethyl pyrazine, ethyl 2-methyl butyrate, ethyl acetate, ethyl butyrate, ethyl hexanoate, ethyl isovalerate, ethyl lactate, ethyl laurate, ethyl levulinate, ethyl maltol, ethyl octanoate, ethyl oleate, ethyl palmitate, ethyl phenylacetate, ethyl propionate, ethyl stearate, ethyl valerate, ethyl vanillin, ethyl vanillin glucoside, 2-ethyl-3,(5 or 6)-dimethyl pyrazine, 5-ethyl-3-hydroxy-4-methyl-2(5H)-furanone, 2-ethyl-3-methyl pyrazine, eucalyptol, fenugreek absolute, gene absolute, gentian root infusion, geraniol, geranyl acetate, grape juice, guaiacol, guava extract, $\gamma$-heptalactone, $\gamma$-hexalactone, hexanoic acid, cis-3-hexen-1-ol, hexyl acetate, hexyl alcohol, hexyl phenylacetate, honey, 4-hydroxy-3-pentenoic acid lactone, 4-hydroxy-4-(3-hydroxy-1-butenyl)-3,5,5-trimethyl-2-cyclohexen-1-one, 4-(para-hydroxyphenyl)-2-butanone, sodium 4-hydroxy decanoate, immortelle absolute, $\beta$-ionone, isoamyl acetate, isoamyl butyrate, isoamyl phenyl acetate, isobutyl acetate, isobutyl phenylacetate, jasmine absolute, kola nut tincture, labdanum oil, lemon terpeneless oil, licorice extract, linalool, linalyl acetate, lovage root oil, maltol, maple syrup, menthol, menthone, L-menthyl acetate, para-methoxy benzaldehyde, methyl-2-pyrrolyl ketone, methyl anthranilate, methyl phenylacetate, methyl salicylate, 4'-methyl acetophenone, methyl cyclopentenolone, 3-metnylvaleric acid, mimosa absolute, molasses, myristic acid, nerol, nerolidol, $\gamma$-nonalactone, nutmeg oil, $\delta$-octalactone, octanal, octanoic acid, orange flower oil, orange oil, orris root oil, palmitic acid, $\omega$-pentadecalactone, peppermint oil, petitgrain Paraguay oil, phenethyl alcohol, phenethyl phenylacetate, phenylacetic acid, piperonal, plum extract, propenyl guaethol, propyl acetate, 3-propylidenephthalide, prune juice, pyruvic acid, raisin extract, rose oil, rum, sage oil, sandalwood oil, spearmint oil, styrax absolute, marigold oil, tea distillate, $\alpha$-terpineol, terpinyl acetate, 5,6,7,8-tetrahydroquinoxaline, 1,5,5,9-tetramethyl-13-oxacyclo (8.3.0.0(4.9)) tridecane, 2,3,5,6-tetramethyl pyrazine, thyme oil, tomato extract, 2-tridecanone, triethyl citrate, 4-(2,6,6-trimethyl-1-cyclohexenyl) 2-butene-4-one, 2,6,6-trimethyl-2-cyclohexen-1,4-dione, 4-(2,6,6-trimethyl-1,3-cyclohexadienyl) 2-butene-4-one, 2,3,5-trimethyl pyrazine, $\gamma$-undecalactone, $\gamma$-valerolactone, vanilla extract, vanillin, veratraldehyde, violet leaf absolute, N-ethyl-p-menthane-3-carboxamide (WS-3), and ethyl-2-(p-menthane-3-carboxamide) acetate (WS-5). Particularly, the type of the flavoring agent is preferably menthol. One type of these flavoring agents may be used solely or two or more types may be used in combination.

The content of the flavoring agent in the tobacco filler 111 is not limited. From the viewpoint of imparting a good flavor, the content of the flavoring agent is commonly higher than or equal to 10000 ppm, preferably higher than or equal to 20000 ppm, and more preferably higher than or equal to 25000 ppm, and the content of the flavoring agent is commonly lower than or equal to 70000 ppm, preferably lower than or equal to 50000 ppm, more preferably lower than or equal to 40000 ppm, and further preferably lower than or equal to 33000 ppm.

[Wrapping Paper]

The wrapping paper 112 is a sheet material for wrapping the tobacco filler 111. The configuration of the wrapping paper 112 is not limited, and a general sheet material may be used. For example, cellulose fiber paper may be used as base paper used for the wrapping paper 112. More specifically, hemp, wood, or a mixture of them may be used. The basis weight of the base paper in the wrapping paper 112 is, for example, commonly greater than or equal to 20 gsm and preferably greater than or equal to 25 gsm. On the other hand, the basis weight is commonly less than or equal to 65 gsm, preferably less than or equal to 50 gsm, and more preferably less than or equal to 45 gsm. The thickness of the wrapping paper 112 having the above characteristics is not limited. From the viewpoint of stiffness, air permeability, and easiness of adjustment during paper manufacturing, the thickness of the wrapping paper 112 is commonly greater than or equal to 10 $\mu$m, preferably greater than or equal to 20 $\mu$m, and more preferably greater than or equal to 30 $\mu$m, and the thickness of the wrapping paper 112 is commonly less than or equal to 100 $\mu$m, preferably less than or equal to 75 $\mu$m, and more preferably less than or equal to 50 $\mu$m.

Examples of the shape of the wrapping paper 112 of the tobacco rod portion 110 (tobacco filler 111) include a square shape and a rectangular shape. When used as the wrapping paper 112 for wrapping the tobacco filler 111 (manufacturing the tobacco rod portion 110), the length of one side may range from about 6 mm to about 70 mm, the length of another one side may range from 15 mm to 28 mm, the preferred length of another one side may range from 22 mm to 24 mm, and the further preferred length may be about 23 mm.

In addition to the above-described pulp, the wrapping paper 112 may contain a filler. The content of the filler may be higher than or equal to 10wt% and lower than 60wt% and preferably higher than or equal to 15wt% and lower than or equal to 45wt% with respect to the total weight of the wrapping paper 112. In the wrapping paper 112, the filler is preferably higher than or equal to 15wt% and lower than or equal to 45wt% within the preferable basis weight range (greater than or equal to 25 gsm and less than or equal to 45 gsm). Furthermore, when the basis weight is greater than or equal to 25 gsm and less than or equal to 35 gsm, the filler is preferably higher than or equal to 15wt% and lower than or equal to 45wt%. When the basis weight is greater than 35 gsm and less than or equal to 45 gsm, the filler is preferably higher than or equal to 25wt% and lower than or equal to 45wt%. Examples of the filler include calcium carbonate, titanium dioxide, and kaolin. From the viewpoint of enhancing flavor and whiteness, or other viewpoints, calcium carbonate is preferably used.

The wrapping paper 112 may be added with various aids in addition to base paper and a filler and may be added with, for example, a water resistance improving agent for improvement in water resistance. The water resistance improving agent includes a wet strength agent (WS agent) and a sizing agent. Examples of the wet strength agent include urea formaldehyde resin, melamine-formaldehyde resin, and polyamide-epichlorohydrin (PAE). Examples of the sizing agent include rosin soap, alkyl ketene dimer (AKD), alkenyl succinic anhydride (ASA), and high-saponification polyvinyl alcohol with a saponification degree of higher than or equal to 90%. A paper strengthening agent may be added as an aid. Examples of the paper strengthening agent include polyacrylamide, cationic starch, oxidized starch, CMC, polyamide epichlorohydrin resin, and polyvinyl alcohol. Particularly, as for oxidized starch, it is known that air permeability improves when a very small amount is used (for example, Japanese Unexamined Patent Application Publication No. 2017-218699). The wrapping paper 112 may be coated as needed.

A coating agent may be added to at least one side of the two front and back sides of the wrapping paper 112. The coating agent is not limited and is preferably a coating agent capable of forming a film on the surface of paper and reducing liquid permeability. Examples of the coating agent include polysaccharides, such as alginic acid and its salts (for example, sodium salt), and pectin, cellulose derivatives, such as ethyl cellulose, methyl cellulose, carboxymethyl cellulose, and nitrocellulose, and starches and their derivatives (for example, ether derivatives, such as carboxymethyl starch, hydroxyalkyl starch, and cationic starch, and ester derivatives, such as starch acetate, starch phosphate, and starch octenyl succinate).

The axial length of the tobacco rod portion 110 can be changed as needed according to the size of a product. For example, the axial length of the tobacco rod portion 110 is greater than or equal to 5 mm, preferably greater than or equal to 10 mm, more preferably greater than or equal to 12 mm, and further preferably greater than or equal to 18 mm, and the axial length of the tobacco rod portion 110 is commonly less than or equal to 70 mm, preferably less than or equal to 50 mm, more preferably less than or equal to 30 mm, and further preferably less than or equal to 25 mm.

<Mouthpiece Portion>

The configuration of the tobacco stick 100 is not limited and may be a general mode. In the mode shown in Fig. 1, the mouthpiece portion 120 includes two segments, that is, a cooling segment 121 and a filter segment 122. The cooling segment 121 is disposed so as to be sandwiched between the tobacco rod portion 110 and the filter segment 122 in a state of being in contact with the tobacco rod portion 110 and the filter segment 122. In another mode, a clearance may be formed between the tobacco rod portion 110 and the cooling segment 121 and between the tobacco rod portion 110 and the filter segment 122. The mouthpiece portion 120 may be made up of a single segment.

[Cooling Segment]

The configuration of the cooling segment 121 is not limited as long as the cooling segment 121 has a function to cool tobacco mainstream smoke. Examples of the cooling segment 121 include the one formed by working thick paper into a cylindrical shape. In this case, the inside of the cylindrical shape is a cavity, and vapor containing an aerosol-source material and a tobacco flavor component contact with air in the cavity to be cooled.

One mode of the cooling segment 121 may be a paper core obtained by working single paper or laminated paper of multiple pieces of sheet into a cylindrical shape. To increase a cooling effect by bringing outside air at room temperature into contact with high-temperature vapor, a hole for introducing outside air is preferably provided around the paper core. Air holes 103 that are perforations for taking in air from an outside are provided in the cooling segment 121. The number of the air holes 103 in the cooling segment 121 is not limited. In the present embodiment, the plurality of air holes 103 is disposed at regular intervals in a circumferential direction of the cooling segment 121. A plurality of groups of the air holes 103 arranged in the circumferential direction of the cooling segment 121 may be formed along the axial direction of the cooling segment 121. Since the cooling segment 121 has the air holes 103, when the tobacco stick 100 is inhaled, low-temperature air flows from the outside into the cooling segment 121 to make it possible to decrease the temperatures of a volatile component and air flowing in from the tobacco rod portion 110. Vapor containing an aerosol-source material and a tobacco flavor component is cooled to condense by the low-temperature air introduced into the cooling segment 121 through the air holes 103. Thus, generation of an aerosol is boosted, and the size of aerosol particles can be controlled. When polymer coating of polyvinyl alcohol or the like or polysaccharide coating of pectin or the like is provided on the inner surface of the paper core, it is possible to increase a cooling effect by taking advantage of heat of dissolution resulting from absorption of heat or phase change of coating. The air-flow resistance of the cylindrical cooling segment is 0 mmH$_2$O.

When a sheet or the like for cooling a volatile component and air flowing from the tobacco rod portion 110 into the cooling segment 121 is filled in the cooling segment 121, the total surface area of the cooling segment 121 is not limited and may be, for example, greater than or equal to 300 mm$^2$/mm and less than or equal to 1000 mm$^2$/mm. The surface area is a surface area per length (mm) of the cooling segment 121 in a ventilation direction. The total surface area of the cooling segment 121 is preferably greater than or equal to 400 mm$^2$/mm and more preferably greater than or equal to 450 mm$^2$/mm, while the total surface area of the cooling segment 121 is preferably less than or equal to 600 mm$^2$/mm and more preferably less than or equal to 550 mm$^2$/mm.

The internal structure of the cooling segment 121 desirably has a large total surface area. Therefore, in a preferred embodiment, the cooling segment 121 may be provided with ridges and grooves to form channels and then may be made up of a sheet of a thin material formed with pleated, gathered, or folded. When there are many folds or pleats in a given volume of an element, the total surface area of the cooling segment 121 increases. The thickness of the constituent material of the cooling segment 121 is not limited and, for example, may be greater than or equal to 5 μm and less than or equal to 500 μm or may be greater than or equal to 10 μm and less than or equal to 250 μm.

Paper is desirably used as the material of the cooling sheet member from the viewpoint of reducing an environmental load. Paper used as a material for a cooling sheet desirably has a basis weight of 30 g/m$^2$ to 100 g/m$^2$ and a thickness of 20 μm to 100 μm. The air permeability of paper to be used as a material for a cooling sheet is desirably lower and the air permeability is preferably lower than or equal to 10 CORESTA from the viewpoint of reducing removal of the flavor source component and the aerosol-source material component in the cooling segment. When polymer poating of polyvinyl alcohol or the like or polysaccharide coating of pectin or the like is provided on the paper serving as a material for a cooling sheet, it is possible to increase a cooling effect by taking advantage of heat of dissolution resulting from absorption of heat or phase change of coating.

The air holes 103 in the cooling segment 121 are preferably disposed at a location 4 mm or longer away from the boundary between the cooling segment 121 and the filter segment 122. Thus, it is possible to not only improve the cooling capacity of the cooling segment 121 but also suppress stagnation of a component generated by heating in the cooling segment 121 to improve the delivery amount of the component. The tipping paper 130 preferably has perforations at locations just above the air holes 103 (locations overlapping up and down) provided in the cooling segment 121. The perforations of the cooling segment 121 are preferably provided such that an air inflow rate through the perforations (a volume percent of air flowing in through the perforations where the percent of air inhaled from a mouthpiece end is 100vol%) when inhaled with an automatic smoking machine at 17.5 ml/s ranges from 10vol% to 90vol%, preferably ranges from 50vol% to 80vol%, and more preferably ranges from 55vol% to 75vol%. For example, the number of perforations V per perforation group is selected from the range of five to 50, the diameter of each perforation V is selected from the range of 0.1 mm to 0.5 mm, and the above configuration is achieved by a combination of these selections. The air inflow rate can be measured with a method compliant with ISO9512 with an automatic smoking machine (for example, a single-barreling automatic smoking machine manufactured by Borgwaldt). The axial length (the length in the ventilation direction) of the cooling segment 121 is not limited. The axial length of the cooling segment 121 is commonly greater than or equal to 10 mm and preferably greater than or equal to 15 mm, and the axial length of the cooling segment 121 is commonly less than or equal to 40 mm, preferably less than or equal to 35 mm, and more preferably less than or equal to 30 mm. The axial length of the cooling segment 121 is particularly preferably set to 20 mm. When the axial length of the cooling segment 121 is greater than or equal to the lower limit, it is possible to ensure a sufficient cooling effect to obtain a good flavor. When the axial length of the cooling segment 121 is less than or equal to the upper limit, it is possible to suppress losses due to adhesion of vapor and aerosol generated during use to an inner wall of the cooling segment 121.

[Filter Segment]

The configuration of the filter segment 122 is not limited as long as the filter segment 122 has the function of a general filter. Examples of the filter segment 122 include the one formed by working cellulose acetate tow into a cylindrical columnar shape. The filament denier and total denier of cellulose acetate tow are not limited. When the filter segment 122 has a circumference of 22 mm, preferably, the filament denier ranges from 5 g/9000m to 20 g/9000m, and the total denier ranges from 12000 g/9000m to 30000 g/9000m. The sectional shape of fiber of cellulose acetate tow may be a Y section or may be an R section. In the case where the filter segment 122 is formed by being filled with cellulose acetate tow, 5wt% or higher and 10wt% or lower of triacetin may be added to the weight of cellulose acetate tow to improve filter hardness. In the example shown in Fig. 2, the filter segment 122 is made up of a single segment. Alternatively, the filter segment 122 may be made up of a plurality of segments. When the filter segment 122 is made up of a plurality of segments, for example, a mode in which a hollow segment, such as a center hole, is disposed on an upstream side (tobacco rod portion 110 side) and an acetate filter in which an inhalation port section is filled with cellulose acetate tow is disposed as a downstream (mouthpiece end 101 side) segment may be provided. With such a mode, it is possible to reduce useless losses of aerosol generated and provide a good external appearance of the tobacco stick 100. From the viewpoint of a change in feeling of satisfactory inhalation and mouthfeel, a mode in which an acetate filter is disposed on an upstream side (tobacco rod portion 110 side) and a hollow segment, such as a center hole, is disposed on a downstream side (mouthpiece end 101 side) may be adopted. The filter segment 122 may be made from another alternative filter material, such as a paper filter filled with sheet pulp paper, instead of the acetate filter.

Examples of a general function of the filter in the filter segment 122 include adjusting the amount of air to be mixed when an aerosol and the like are inhaled, reducing a flavor, and reducing nicotine and tar; however, the filter does not need to have all of these functions. In an electrically heated tobacco product that tends to have a smaller amount of component generated and a lower packing fraction of tobacco filler as compared to a cigarette product, it is also one of important functions to reduce falling of tobacco filler while suppressing a filtering function.

The cross-sectional shape of the filter segment 122 is substantially a circular shape, and the diameter of the circle can be changed as needed according to the size of a product. The diameter of the circle is commonly greater than or equal to 4.0 mm and less than or equal to 9.0 mm, preferably greater than or equal to 4.5 mm and less than or equal to 8.5 mm, and more preferably greater than or equal to 5.0 mm and less than or equal to 8.0 mm. When the section is not in a circular shape, a diameter of a circle having the same area as the area of the section is applied as the diameter The circumference of the filter segment 122 can be changed as needed according to the size of a product. The circumference of the filter segment 122 is commonly greater than or equal to 14.0 mm and less than or equal to 27.0 mm, preferably greater than or equal to 15.0 mm and less than or equal to 26.0 mm, and more preferably greater than or equal to 16.0 mm and less than or equal to 25.0 mm. The axial length of the filter segment 122 can be changed as needed according to the size of a product. The axial length of the filter segment 122 is commonly greater than or equal to 5 mm and less than or equal to 35 mm, and preferably greater than or equal to 10.0 mm and less than or equal to 30.0 mm. The shape and dimensions of a filter element may be adjusted as needed such that the shape and dimensions of the filter segment 122 respectively fall within the above-described ranges.

The air-flow resistance of the filter segment 122 per axial length 120 mm is not limited. The air-flow resistance of the filter segment 122 is commonly higher than or equal to 40 mmH$_2$O and lower than or equal to 300 mmH$_2$O, preferably higher than or equal to 70 mmH$_2$O and lower than or equal to 280 mmH$_2$O, and more preferably higher than or equal to 90 mmH$_2$O and lower than or equal to 260 mmH$_2$O. The air-flow resistance is measured with, for example, a filter air-flow resistance measuring device made by Cerulean in compliant with an ISO standard method (ISO6565). The air-flow resistance of the filter segment 122 indicates a difference in air pressure between a first end surface and a second end surface when air is flowed at a predetermined air flow rate (17.5 cc/min) from one end surface (first end surface) to the other end surface (second end surface) in a state where permeation of air does not occur at the side of the filter segment 122. The air-flow resistance can be generally expressed in mmHzO. It is known that the relationship between the air-flow resistance of the filter segment 122 and the length of the filter segment 122 is a proportional relationship in an ordinarily used length range (a length of 5 mm to 200 mm). When the length of the filter segment 122 is doubled, the air-flow resistance is also doubled.

The density of the filter element in the filter segment 122 is not limited. The density of the filter element is commonly greater than or equal to 0.10 g/cm$^3$ and less than or equal to 0.25 g/cm$^3$, preferably greater than or equal to 0.11 g/cm$^3$ and less than or equal to 0.24 g/cm$^3$, and more preferably greater than or equal to 0.12 g/cm$^3$ and less than or equal to 0.23 g/cm$^3$. The filter segment 122 may include wrapping paper (filter plug wrapping paper) that wraps a filter element and the like from the viewpoint of improvement in strength and structural stiffness. The mode of wrapping paper is not limited and may include a joint including one or more lines of an adhesive. The adhesive may contain a hot-melt adhesive. In addition, the hot-melt adhesive can contain polyvinyl alcohol. When the filter segment 122 is made up of two or more segments, wrapping paper preferably wraps these two or more segments together. The material of wrapping paper in the filter segment 122 is not limited. A known material may be used. Also, the material of wrapping paper may contain a filler, such as calcium carbonate, or the like.

The thickness of the wrapping paper is not limited. The thickness of the wrapping paper is commonly greater than or equal to 20 μm and less than or equal to 140 μm, preferably greater than or equal to 30 μm and less than or equal to 130 μm, and more preferably greater than or equal to 30 μm and less than or equal to 120 μm. The basis weight of the wrapping paper is not limited. The basis weight of the wrapping paper is commonly greater than or equal to 20 gsm and less than or equal to 100 gsm, preferably greater than or equal to 22 gsm and less than or equal to 95 gsm, and more preferably greater than or equal to 23 gsm and less than or equal to 90 gsm. The wrapping paper may be coated or not coated. From the viewpoint of imparting a function other than strength or structural stiffness, the wrapping paper is preferably coated with a desired material.

When the filter segment 122 includes a center hole segment and a filter element, the center hole segment and the filter element may be connected by, for example, an outer plug wrapper (outer wrapping paper). The outer plug wrapper may be, for example, cylindrical paper. The tobacco rod portion 110, the cooling segment 121, and the connected center hole segment and filter element may be connected by, for example, a mouthpiece lining paper. Connection of them may be performed by, for example, applying paste, such as vinyl acetate paste, on the inner surface of the mouthpiece lining paper, putting the tobacco rod portion 110, the cooling segment 121, and the connected center hole segment and filter element in the mouthpiece lining paper, and rolling the mouthpiece lining paper. These may be connected separately with a plurality of pieces of lining paper multiple times.

The filter element of the filter segment 122 may include a breakable additive releasing container (for example, a capsule) including a breakable outer shell, such as gelatin. The mode of the capsule (which may also be referred to as "additive releasing container" in the technical field) is not limited. A known mode may be adopted. The mode of the capsule may be, for example, a breakable additive releasing container including a breakable outer shell, such as gelatin. The form of the additive releasing container is not limited. Examples of the form of the capsule include an easily breakable capsule and the shape of the capsule is preferably spherical. An additive contained in the capsule may include the above-described selected additive and particularly preferably includes a flavor agent and activated carbon. One or more kinds of materials that help filtering smoke may be added as an additive. The form of the additive is not limited and is commonly liquid or individual. Using a capsule containing an additive is known in the technical field. An easily breakable capsule and its manufacturing method are known in the technical field.

The flavor agent may be, for example, menthol, spearmint, peppermint, fenugreek, clove, medium-chain triglyceride (MCT), or the like, or a combination of any two or more of them. The flavor agent according to the present embodiment is menthol.

The filter element of the filter segment 122 may be added with a flavoring agent. Since the filter element is added with a flavoring agent, the delivery amount of a flavoring agent during use increases as compared to the existing art in which a flavoring agent is added to a tobacco filler that is a component of the tobacco rod portion 110. A degree to which the delivery amount of a flavoring agent further increases in accordance with the locations of perforations provided in the cooling segment 121. A method of adding a flavoring agent to the filter element is not limited, and a flavoring agent just has to be added so as to be uniformly dispersed in the filter element to which a flavoring agent is added. The additive amount of a flavoring agent may be a mode of adding the flavoring agent to a part with 10vol% to 100vol% of the filter element. The adding method may be adding a flavoring agent to the filter element in advance before the filter segment is formed or may be adding a flavoring agent after the filter segment is formed. The type of flavoring agent is not limited and may be the one similar to the flavoring agent contained in the above-described tobacco filler 111.

The filter segment 122 may include a filter element, and activated carbon may be added to at least part of the filter element. The additive amount of activated carbon to the filter element may be greater than or equal to 15.0 $m^2/cm^2$ and less than or equal to 80.0 $m^2/cm^2$ as a value of (Specific surface area of activated carbon)$\times$(Weight of activated carbon)/(Sectional area of the filter element in a direction perpendicular to the ventilation direction) for one tobacco stick 100. The above "(Specific surface area of activated carbon)$\times$(Weight of activated carbon)/(Sectional area of the filter element in a direction perpendicular to the ventilation direction)" may be referred to as "the surface area of activated carbon per unit sectional area" for the sake of convenience. The surface area of activated carbon per unit sectional area can be calculated in accordance with the specific surface area of activated carbon added to the filter element of one tobacco stick 100, the weight of activated carbon added, and the sectional area of the filter element. Activated carbon can be dispersed not uniformly in a filter element to which the activated carbon is added, and fulfillment of the above range is not required in all the sections of the filter element (the sections in a direction perpendicular to the ventilation direction).

The surface area of activated carbon per unit sectional area is more preferably greater than or equal to 17.0 $m^2/cm^2$ and further preferably greater than or equal to 35.0 $m^2/cm^2$. On the other hand, the surface area of activated carbon per unit sectional area is more preferably less than or equal to 77.0 $m^2/cm^2$ and further preferably less than or equal to 73.0 $m^2/cm^2$. The surface area of activated carbon per unit sectional area can be adjusted by adjusting, for example, the specific surface area and additive amount of activated carbon and the sectional area of the filter element in a direction perpendicular to the ventilation direction. The surface area of activated carbon per unit sectional area is calculated with reference to the filter element to which activated carbon is added. When the filter segment 122 is made up of a plurality of filter elements, the sectional area and length of only the filter element to which activated carbon is added are used as a reference.

Examples of the activated carbon include the ones made from wood, bamboo, coconut shell, walnut shell, coal, and the like as raw materials. Activated carbon having a BET specific surface area greater than or equal to 1100 $m^2/g$ and less than or equal to 1600 $m^2/g$ may be used, preferably activated carbon having a BET specific surface area greater than or equal to 1200 $m^2/g$ and less than or equal to 1500 $m^2/g$ may be used, and more preferably activated carbon having a BET specific surface area greater than or equal to 1250 $m^2/g$ and less than or equal to 1380 $m^2/g$ may be used. A BET specific surface area can be obtained with a nitrogen gas adsorption method (BET multipoint method). Activated carbon having a pore volume greater than or equal to 400 $\mu$L/g and less than or equal to 800 $\mu$L/g may be used, more preferably activated carbon having a pore volume greater than or equal to 500 $\mu$L/g and less than or equal to 750 $\mu$L/g may be used, and more preferably activated carbon having a pore volume greater than or equal to 600 $\mu$L/g and less than or equal to 700 $\mu$L/g may be used. A pore volume can be calculated from a maximum adsorption amount obtained by using a nitrogen gas adsorption method. The additive amount of activated carbon per unit length, in the ventilation direction, of the filter element added with activated carbon is preferably greater than or equal to 5 mg/cm and less than or equal to 50 mg/cm, more preferably greater than or equal to 8 mg/cm and less than or equal to 40 mg/cm, and further preferably greater than or equal to 10 mg/cm and less than or equal to 35 mg/cm. When the specific surface area of activated carbon and the additive amount of activated carbon respectively fall within the above ranges, the surface area of activated carbon per unit sectional area can be adjusted to a desired one.

As activated carbon, an accumulated 10vol% particle size (particle size D10) of activated carbon particles is preferably greater than or equal to 250 $\mu$m and less than or equal to 1200 $\mu$m. An accumulated 50vol% particle size (particle size D50) of activated carbon particles is preferably greater than or equal to 350 $\mu$m and less than or equal to 1500 $\mu$m. The particle sizes D10 and D50 can be measured with a laser diffraction scattering method. A laser scattering particle size distribution analyzer "LA-950" made by HORIBA, Ltd. can be a device suitable for the measurement. Powder together with pure water is flowed into a cell of the analyzer, and a particle size is detected in accordance with light scattering information of particles.

Measurement conditions with the analyzer are as follows.
Measurement mode: Manual flow mode cell measurement
Dispersion medium: Ion-exchanged water
Dispersion method: Measurement after application of ultrasonic wave for a minute
Refractive index: 1.92-0.00i (sample refraction)/1.33-0.00i (dispersion medium refractive index)
Number of measurements: Twice with a different sample

A method of adding activated carbon to the filter element of the filter segment 122 is not limited. Activated carbon just needs to be added so as to be dispersed substantially uniformly in the filter element that is an object to be added with activated carbon.

The thus configured tobacco stick 100 may be coated with a lip-release material on part of the outer surface of the tipping paper 130. A lip-release material means a material configured to, when a user puts the mouthpiece portion 120 of the tobacco stick 100 in the mouth, aid contact between the lip and the tipping paper 130 to easily separate without substantial adhesion. Examples of the lip-release material may include ethyl cellulose and methyl cellulose. For example, the outer surface of the tipping paper 130 may be coated with a lip-release material by applying ethyl cellulose ink or methyl cellulose ink to the outer surface of the tipping paper 130.

In the present embodiment, the lip-release material of the tipping paper 130 is disposed in at least a predetermined mouthpiece region that, when a user puts the mouthpiece portion 120 in the mouth, contacts with the lip of the user. More specifically, on the outer surface of the tipping paper 130, a lip-release material region R1 (see Fig. 2) coated with the lip-release material is defined as a region located between the mouthpiece end 101 of the mouthpiece portion 120 and the air holes 103.

The air-flow resistance of the thus configured tobacco stick 100 in a long-axis direction per one stick is not limited. From the viewpoint of inhalation easiness, the air-flow resistance of the tobacco stick 100 is commonly higher than or equal to 8 mmH$_2$O, preferably higher than or equal to 10 mmH$_2$O, and more preferably higher than or equal to 12 mmH$_2$O, and the air-flow resistance of the tobacco stick 100 is commonly lower than or equal to 100 mmH$_2$O, preferably lower than or equal to 80 mmH$_2$O, and more preferably lower than or equal to 60 mmHzO. The air-flow resistance is measured with, for example, a filter air-flow resistance measuring device made by Cerulean in compliant with an ISO standard method (ISO6565: 2015). The air-flow resistance indicates a difference in air pressure between a first end surface and a second end surface when air is flowed at a predetermined air flow rate (17.5 cc/min) from one end surface (first end surface) to the other end surface (second end surface) in a state where permeation of air does not occur at the side of the tobacco stick 100. The unit is generally mmH$_2$O. It is known that the relationship between the air-flow resistance and the tobacco stick 100 is a proportional relationship in an ordinarily used length range (a length of 5 mm to 200 mm). When the length of the tobacco stick 100 is doubled, the air-flow resistance is also doubled.

The rod-like tobacco stick 100 preferably has a columnar shape that satisfies a shape of which an aspect ratio defined as follows is higher than or equal to one.

$$\text{Aspect ratio} = h/w$$

w denotes the width of the distal end 102 in the tobacco stick 100, h denotes the axial length, and it is preferable that $h \geq w$. The cross-sectional shape of the tobacco stick 100 is not limited and may be a polygonal shape, a rounded polygonal shape, a circular shape, an elliptical shape, or the like. The width w in the tobacco stick 100 is a diameter when the cross-sectional shape of the tobacco stick 100 is a circular shape, a longitudinal diameter when the cross-sectional shape of the tobacco stick 100 is an elliptical shape, or a diameter of a circumcircle or a longitudinal diameter of a circumellipse when the cross-sectional shape of the tobacco stick 100 is a polygonal shape or a rounded polygonal shape. The axial length h of the tobacco stick 100 is not limited. The axial length h of the tobacco stick 100 is, for example, commonly greater than or equal to 40 mm, preferably greater than or equal to 45 mm, and more preferably greater than or equal to 50 mm. The axial length h of the tobacco stick 100 is commonly less than or equal to 100 mm, preferably less than or equal to 90 mm, and more preferably less than or equal to 80 mm. The width w of the distal end 102 of the tobacco stick 100 is not limited and is, for example, commonly greater than or equal to 5 mm and preferably greater than or equal to 5.5 mm. The width w of the distal end 102 of the tobacco stick 100 is commonly less than or equal to 10 mm, preferably less than or equal to 9 mm, and more preferably less than or equal to 8 mm. The ratio between the length of the cooling segment 121 and the length of the filter segment 122 ((Cooling segment): (Filter segment)) in the length of the tobacco stick 100 is not limited. From the viewpoint of the delivery amount of a flavoring agent and an appropriate aerosol temperature, the ratio commonly ranges from 0.60:1.40 to 1.40:0.60, preferably ranges from 0.80:1.20 to 1.20:0.80, more preferably ranges from 0.85:1.15 to 1.15:0.85, further preferably ranges from 0.90:1.10 to 1.10:0.90, and particularly preferably ranges from 0.95:1.05 to 1.05:0.95. When the ratio between the length of the cooling segment 121 and the length of the filter segment 122 falls within the above range, a balance is kept among a cooling effect, the effect of suppressing losses resulting from adhesion of generated vapor and aerosol to the inner wall of the cooling segment 121, and a function of the filter to adjust the amounts of air and a flavor, so it is possible to realize a good flavor and the strength of a flavor.

<Non-Combustion-Type Flavor Inhaler>

Fig. 4 is view schematically showing the internal structure of a non-combustion-type flavor inhaler 30 according to the first embodiment. The non-combustion-type flavor inhaler 30 has a housing 31 that is a casing for accommodating various components. A heater 32, a capacitance sensor 33, a temperature sensor 35, an inhalation sensor 36, a controller 37, a power supply 38, and the like are accommodated in the housing 31.

[Container]

The housing 31 has a container 310 that extends from a front end toward a back end. The container 310 accommodates the tobacco stick 100 so that the tobacco stick 100 can be inserted and removed. The container 310 includes a cylindrical circumferential wall 312 and a disk-shaped back wall 311. The circumferential wall 312 extends in an insertion and removal direction of the tobacco stick 100 and defines the outer circumference of a space in which the tobacco stick 100 is inserted. The back wall 311 closes the back end of the circumferential wall 312 so as to define the back end of the space. The circumferential wall 312 and the back wall 311 of the container 310 may be formed integrally with the housing 31 or may be formed separately from the housing 31 and assembled to the housing 31.
An opening end of the circumferential wall 312 in the container 310 is open toward the outside of the housing 31 and serves as an insertion port 3A for inserting the tobacco stick 100. Then, an internal space of the circumferential wall 312 is a cylindrical columnar container cavity 313 that allows a distal end part of the tobacco stick 100 to be inserted and removed via the insertion port 3A. In Fig. 4, the reference sign CL indicates a central axis of the container cavity 313 in the insertion and removal direction of the tobacco stick 100. Hereinafter, a direction along the central axis CL is also referred to as axial direction. The outside diameter of the container cavity 313, that is, the inside diameter of the circumferential wall 312, may be equal to the outside diameter of the tobacco stick 100 or may be slightly greater than the outside diameter of the tobacco rod portion 110 or may be slightly less than the outside diameter of the tobacco rod portion 110.
The heater 32 is provided in the container cavity 313. The circumferential wall 312 and the back wall 311 of the container 310 is made of a material having a heat insulation capability and a heat resistance capability so as to withstand heat from the heater 32 and not to disperse heat from the heater 32. Examples of the material used for such the container 310 include a ceramic of alumina-silica, and resins, such as high-heat-resistant PEEK (polyetheretherketone), PPS (polyphenylene sulfide), and PTFE (polytetrafluoroethylene).

[Heater]

The heater 32 generates heat upon receiving electric power supplied from the controller 37 to heat the tobacco stick 100 accommodated in the container 310. In other words, the heater 32 is one mode of the heater that heats the tobacco stick 100.
The heater 32 is a substantially rod-shaped member extended along the axial direction of the container cavity 313 and has a cone shape in the present embodiment. The heater 32 protrudes forward from the center of the back wall 311 along the axial direction in the container 310. The reference sign 321 indicates a proximal end of the heater 32. The reference sign 322 indicates a distal end of the heater 32.
The heater 32 extends from the back wall 311 toward the insertion port 3A and gradually tapers from the proximal end 321 toward the distal end 322. The shape of the heater 32 is not limited. The shape of the heater 32 may be a rod shape with the same diameter from the proximal end 321 to the distal end 322 or a planar shape (blade shape).
The type of the heater 32 is not limited. For example, a configuration in which a heating wire (for example, a wire rod with a large electrical resistance, such as nichrome, iron-chromium, and iron-nickel) running around a steel material and disposed or a ceramic heater, a sheathed heater, or the like may be used. A sheathed heater is a heater in which a heating wire is covered with a metal pipe together with a filler.
When the tobacco stick 100 is inserted in the container cavity 313, the heater 32 is fitted into the tobacco rod portion 110 from the distal end 102 of the tobacco stick 100. Fig. 1 shows a state where the tobacco stick 100 is inserted in the container cavity 313. In this state, the heater 32 heats the tobacco rod portion 110 at a predetermined temperature upon receiving electric power supplied from the controller 37 (as will be described later). Here, in the container cavity 313, a space that is heated at a predetermined temperature with heat from the heater 32 is defined as heating region A1, and a space adjacent to the insertion port side of the heating region A1 in the axial direction (insertion and removal direction) is defined as non-heating region A2. The non-heating region A2 is formed on the insertion port side of the container cavity 313, and the heating region A1 is formed on the deeper side of the container cavity 313. Here, the heater 32 extends along the central axis CL in the heating region A1, and the heating region A1 is heated from inside. The heater 32 does not heat only a portion in contact and also heats a portion away from the heater 32 by radiation and heat transfer. For example, the heater 32 heats up to a location 317 on the insertion port side beyond the front end of the heater 32A in the axial direction at a predetermined temperature. For this reason, the heating region A1 is a region from the location 317 to the back wall 311 in the axial direction of the container 310. In other words, the location 317 is a boundary between the heating region A1 and the non-heating region A2. The non-heating region A2 ranges from the boundary 317 to the front end of the container cavity 313 in the axial direction. The boundary 317 may be determined as a boundary between a region that becomes a predetermined temperature and a region that becomes lower than the predetermined temperature when actually heated with the heater 32 or may be determined as an estimated boundary that is estimated between a region that becomes a predetermined temperature and a region that becomes lower than the predetermined temperature when the heater 32 is caused to generate heat under a preset condition. In the present embodiment, a boundary location between a region that becomes a predetermined temperature and a region that becomes lower than the predetermined temperature is estimated in the central axis CL, and a plane passing through the boundary location and orthogonal to the central axis CL is determined as the boundary 317 as indicated by the alternate long and two short dashes line in Fig. 4. When the tobacco stick 100 is inserted in the container cavity 313, the tobacco rod portion 110 is located in the heating region A1, and at least part of the mouthpiece portion (inhalation port) 120 is located in the non-heating region A2. When the tobacco stick 100 is set to a preset state, for example, the tobacco stick 100 is inserted in the container cavity 313 until the distal end 102 of the tobacco stick 100 contacts with the back wall 311 of the container 310, a part of the container cavity 313 where the tobacco rod portion 110 is located may be defined as the heating region A1, and a part where the mouthpiece portion 120 is located may be defined as the non-heating region A2.

[Sensor]

The capacitance sensor 33 is a capacitance sensor that detects the capacitance at a location where at least the tobacco rod portion 110 is disposed when the tobacco stick 100 is accommodated in the container 310. The capacitance sensor 33 has a first electrode (first electrode) 301 and a second electrode (second electrode) 302 and detects a capacitance between these first electrode 301 and second electrode 302. The first electrode 301 and the second electrode 302 are disposed at opposite locations across the heating region A1 in a direction orthogonal to the axial direction of the container cavity 313 (radial direction). In other words, the first electrode 301 and the second electrode 302 are disposed such that, when the tobacco stick 100 is accommodated in the container cavity 313, at least part of the tobacco rod portion 110 is inserted between the first electrode 301 and the second electrode 302. At this time, a capacitance that is generated between the electrodes 301, 302 via the tobacco rod portion 110 changes depending on, for example, the presence or absence of insertion of the tobacco rod portion 110, an inserted location of the tobacco rod portion 110, an amount of moisture of a tobacco filler in the tobacco rod portion 110, and the like. For this reason, the capacitance sensor 33 can detect information indicating the state of the tobacco rod portion 110 by detecting the capacitance.

The electrodes 301, 302 are provided on the outer periphery 360 of the circumferential wall 312 of the container 310 at least along a container cavity depth direction (Z-axis direction). Here, the outer periphery 360 of the circumferential wall 312 is a surface opposite to a surface (inner periphery) 361 on the container cavity 313 side across the circumferential wall 312 in the radial direction of the circumferential wall 312 and is a surface located on an internal space side where the capacitance sensor 33, the controller 37, and the like are accommodated in the housing 31.

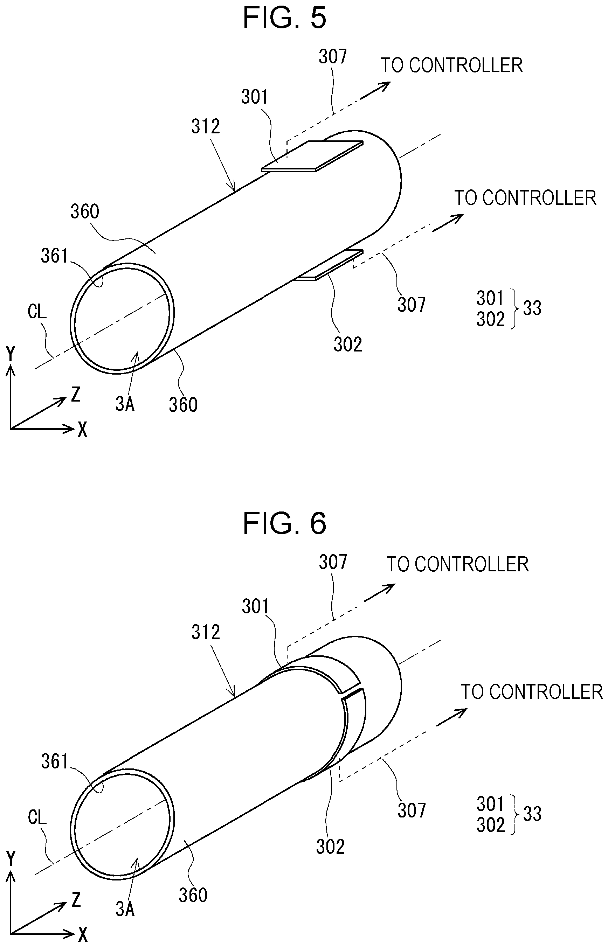

Fig. 5 is a view showing an example in which the planar electrodes 301, 302 are disposed. As shown in Fig. 5, in the capacitance sensor 33, the planar first electrode 301 and the planar second electrode 302 are provided at opposite locations on the outer periphery 360 across the circumferential wall 312 in the radial direction. The first electrode 301 and the second electrode 302 are held parallel to each other in a state of being in contact with the outer periphery 360. The first electrode 301 and the second electrode 302 are electrically connected to the controller 37 via a wiring line 307, and a detection result of capacitance is acquired by the controller.

The shape of each of the electrodes 301, 302 is not limited and may be a shape other than a planar shape. Fig. 6 is a view showing an example in which the curved electrodes 301, 302 are disposed. In the example of Fig. 6, each of the electrodes 301, 302 is provided so as to be curved along the circumferential direction of the outer periphery 360 of the circumferential wall 312. The other configuration is the same as the example of Fig. 5. As shown in Fig. 6, with the curved electrodes 301, 302, it is easier to reduce the size in the radial direction as compared to the example of Fig. 5. With the curved electrodes 301, 302, each of the electrodes 301, 302 is placed along the container cavity 313 in the circumferential direction and disposed at a location close to the tobacco stick 100 over the entire region in the circumferential direction, so the influence of noise is reduced, and the capacitance can be accurately detected.

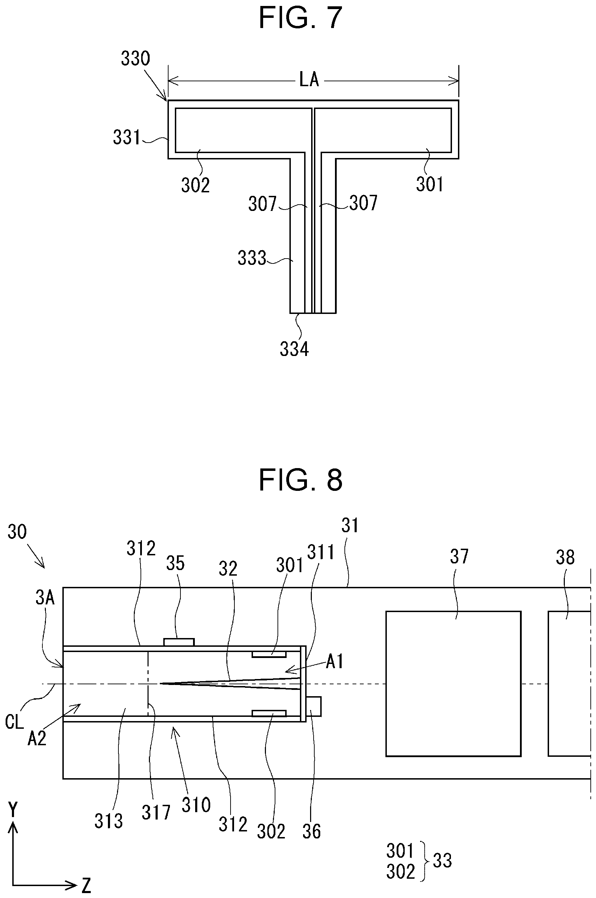

Fig. 7 is a view showing an example of the capacitance sensor 33 formed on a flexible circuit board. The flexible circuit board 330 includes a first strip portion 331 formed long in one direction, and a second strip portion 333 formed long in a direction orthogonal to the first strip portion 331 from a central part of the first strip portion 331 in a longitudinal direction.

In the first strip portion 331, the first electrode 301 of the capacitance sensor 33 is provided on one side and the second electrode 302 is disposed on the other side in the longitudinal direction at a predetermined distance provided at the center in the longitudinal direction. In the second strip portion 333, the wiring lines 307 respectively connected to the electrodes 301, 302 are formed to an end 334 along the longitudinal direction of the second strip portion 333 so as to connect with the controller 37.

The first strip portion 331 is formed such that a length LA in the longitudinal direction is substantially the same or slightly shorter than a length in the circumferential direction on the outer periphery 360 of the circumferential wall 312. When the first strip portion 331 of the flexible circuit board 330 is disposed along the outer periphery 360 of the container 310, the electrodes 301, 302 curved as shown in Fig. 6 can be curved and provided.

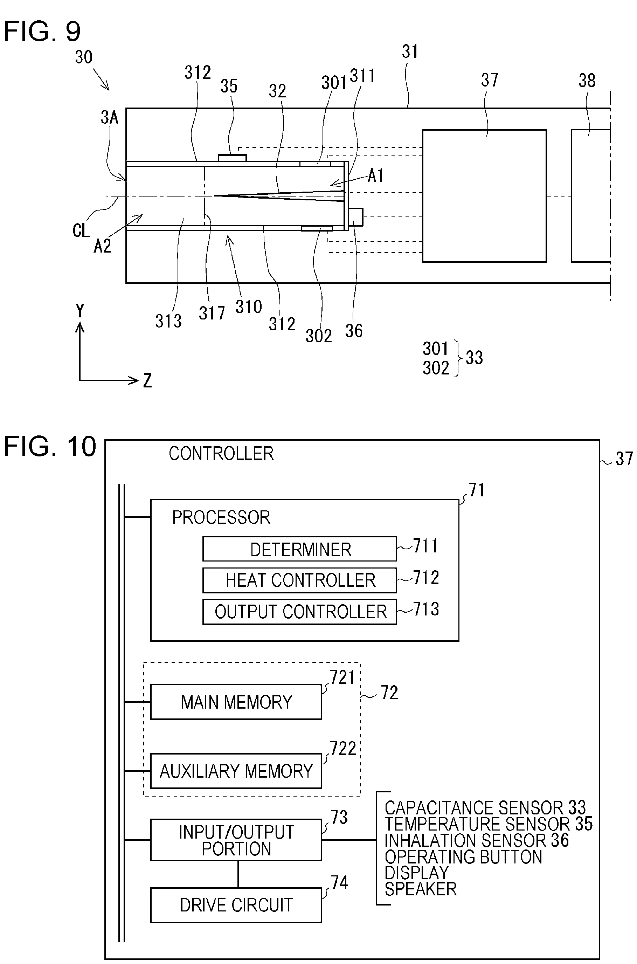

In the examples of Figs. 5 and 6, the electrodes 301, 302 are provided on the outer periphery 360 of the circumferential wall 312; however, the configuration is not limited thereto. As shown in Fig. 8, the electrodes 301, 302 may be provided on the inner periphery 361 of the circumferential wall 312. Furthermore, as shown in Fig. 9, the electrodes 301, 302 may be embedded in the circumferential wall 312.

As shown in Fig. 1, the temperature sensor 35 is provided around an outer peripheral part of the heating region A1 in the container 310. The temperature sensor 35 is connected to the controller 37. The temperature sensor 35 detects the temperature of the heating region A1 and inputs a detection result to the controller 37. Furthermore, the inhalation sensor 36 is provided at the container 310. The inhalation sensor 36 is a sensor for detecting the status of puff, such as whether puff is performed, and is, for example, a pressure sensor that detects a pressure in the container cavity 313. The inhalation sensor 36 is connected to the controller 37 and inputs a detection result to the controller 37. When the controller 37 does not use information on the temperature for control, the temperature sensor 35 may be omitted. Similarly, when information on inhalation is not used for control, the inhalation sensor 36 may be omitted.

[Controller]

Fig. 10 is a view showing the configuration of the controller 37. The controller 37 controls the operating state of the non-combustion-type flavor inhaler 30, such as control for heating with the heater 32. The controller 37 is a computer that includes, for example, a processor 71, such as a CPU (Central Processing Unit), a DSP (Digital Signal Processor), and an FPGA (Field-Programmable Gate Array), a memory 72, such as a RAM (Random Access Memory) and a ROM (Read Only Memory), and an input/output portion 73. The controller 37 according to the present embodiment includes a drive circuit 74 of the heater 32.

The memory 72 may include the one that functions as a main memory 721 and the one that functions as an auxiliary memory 722. The memory 72 may be integrated with the processor 71 (one chip). Examples of the memory 72 include a volatile memory, such as a RAM, a nonvolatile memory, such as a ROM, an EPROM (Erasable Programmable ROM), an SSD, a storage medium, such as a removable medium.

An operating system (OS), various programs (firmware), various data tables, various databases, setting data, user data, and the like for executing the operation of the non-combustion-type flavor inhaler 30 can be stored in the memory 72.

The input/output portion 73 is a means that inputs information, such as turning on or off of power by a user (smoker), to the processor 71 or outputs information to the user. The input/output portion 73 is, for example, an interface that operates the capacitance sensor 33, the temperature sensor 35, and the inhalation sensor 36 at predetermined timing and acquires detection values from the sensors 33, 35, 36. The input/output portion 73 according to the present embodiment may include an operating button, an input means, such as a touch panel, and an output means, such as a display, a vibrator, and a speaker. The input/output portion 73 may include a communicator for communicating with an external apparatus via a communication line. For example, the communicator can update firmfare, a heating profile, and the like by connecting with another computer via a communication cable, receiving a program and data for controlling the non-combustion-type flavor inhaler 30, and storing the program and data in the memory 72. The display is a means that displays information and may be, for example, an indicator, such as an LED, a liquid crystal display device, or an organic EL display device.

The drive circuit 74 causes the heater 32 to operate by supplying electric power from the power supply 38 to the heater 32 in accordance with an instruction from the processor 71. The drive circuit 74 is, for example, a converter that adjusts the amount of current to be passed through the heater 32.

The controller 37 functions as predetermined functional units, for example, a determiner 711, a heat controller 712, and an output controller 713, when the processor 71 reads a program stored in the memory 72 to a working area of the main memory and runs the program. These functional units are not limited to those implemented based on a program (software). Part or all of them may be made up of a hardware circuit, such as a processor, an integrated circuit, and a logic circuit.

The determiner 711 determines operation by a user, the state of the tobacco stick 100, and a heating status by the heater 32 based on detection results of the sensors 33, 35, 36 and input information from the input means. For example, the determiner 711 determines at least one of the presence or absence of the tobacco stick 100, an inserted location of the tobacco stick 100, whether the tobacco stick 100 is already heated, the amount of moisture of the tobacco stick 100, the amount of aerosol source of the tobacco stick 100, the amount of flavor source of the tobacco stick 100, and the type of flavor stick, from a detection value of the capacitance sensor 33.

The determiner 711 determines the state of the tobacco stick 100 based on a first detection value detected by the capacitance sensor 33 at first timing after insertion of the tobacco stick 100 and a second detection value detected at second timing after the first timing. For example, the determiner 711 determines whether the amount of moisture, the amount of flavor source, or the like in the tobacco rod portion 110 has reduced and it is a state to change the heating temperature or a state to end heating. A determination condition and the like for these will be described later.

The heat controller 712 controls electric power supplied from the power supply 38 to the heater 32 via the drive circuit 74 by controlling the drive circuit 74 based on a determination result of the determiner 711. For example, the heat controller 712 executes control to start heating when it is determined that the tobacco stick 100 is inserted in the container cavity 313 or to perform heating with a heating profile according to this type when the type of the tobacco stick 100 is determined. When the determiner 711 determines that the amount of moisture or the amount of flavor source in the tobacco rod portion 110 has reduced to a predetermined amount, the heat controller 712 changes the heating temperature by chanting electric power supplied to the heater 32. Furthermore, when the determiner 711 determines that the amount of moisture or the amount of flavor source in the tobacco rod portion 110 has reduced and it is a state to end heating, the heat controller 712 stops electric power supplied to the heater 32 to end heating.

The output controller 713 outputs a notification, a warning, or the like to the user based on a determination result of the determiner 711. For example, the output controller 713 outputs a warning when the inserted location of the tobacco stick 100 is not appropriate. As output to the user, the output controller 713 outputs a warning or the like by, for example, displaying on the display, voice output with the speaker, or vibration with a vibrator.

[Detection of Tobacco Stick with Capacitance Sensor]

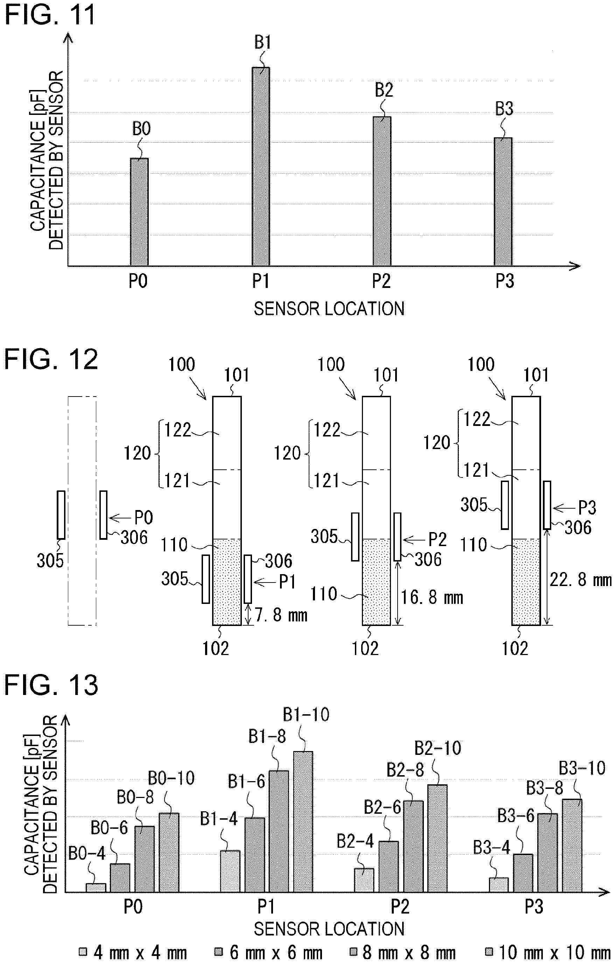

Fig. 11 is a graph showing results obtained by measuring a capacitance in a case where the tobacco stick 100 is not inserted between the electrodes 305, 306 of the capacitance sensor and in a case where a location of the electrodes 305, 306 with respect to the tobacco stick 100 are varied. Fig. 12 is a view showing a positional relationship between the tobacco stick 100 and the electrodes 305, 306 when measurement of Fig. 11 is performed.

As shown in Fig. 12, the electrode 305 and the electrode 306 sandwich the tobacco stick 100 in the radial direction, and a capacitance is detected at different locations P1 to P3 in the longitudinal direction of the tobacco stick 100. The location P1 is such that a distance from the distal end of the tobacco stick 100 to the distal end of the electrodes is set to 7.8 mm and is a location where the tobacco rod portion 110 is located between the electrodes 305, 306 The location P2 is such that a distance from the distal end of the tobacco stick 100 to the distal end of the electrodes is set to 16.8 mm and is a location where a boundary between the tobacco rod portion 110 and the mouthpiece portion 120 is located between the electrodes 305, 306 The location P3 is such that a distance from the distal end of the tobacco stick 100 to the distal end of the electrodes is set to 22.8 mm and is a location where the mouthpiece portion 120 is located between the electrodes 305, 306 The electrode 305 and the electrode 306 are disposed opposite to each other at the same distance as the locations P1 to P3. A capacitance is detected in a state P0 where the tobacco stick 100 is not inserted between the electrodes 305, 306. Fig. 11 shows detection results of capacitance with the electrodes 305, 306 by bars B0 to B3 where the abscissa axis represents the location of a sensor and the ordinate axis represents capacitance.

Here, a detection result indicated by the bar B0 is the one detected in a state P0 where the tobacco stick 100 is not inserted between the electrodes 305, 306, and corresponds to the detection result of the capacitance sensor 33 in a state before the tobacco stick 100 is inserted in the container cavity 313 shown in Fig. 5.

A detection result indicated by the bar B1 is the one detected when the electrodes 305, 306 are disposed at the location P on the outer peripheral side of the tobacco rod portion 110 in the tobacco stick 100. A detection result indicated by the bar B1 corresponds to the detection result of the capacitance sensor 33 in a state where the tobacco stick 100 is inserted in the container cavity 313 shown in Fig. 5.

A detection result indicated by the bar B2 is the one detected when the electrodes 305, 306 are disposed at the location P2 on the outer peripheral side astride the tobacco rod portion 110 and the mouthpiece portion 120 in the tobacco stick 100.

A detection result indicated by the bar B3 is the one detected when the electrodes 305, 306 are disposed at the location P3 on the outer peripheral side of the mouthpiece portion 120 in the tobacco stick 100.

As shown in Fig. 11, when the tobacco stick 100 is inserted, the capacitance at any of the locations P1 to P3 becomes greater than the capacitance in a state P0 where the tobacco stick 100 is not inserted. This is presumably because of the following reason. In comparison with a case where the tobacco stick 100 is not inserted and a substance present between the electrodes 305, 306 is air, the tobacco stick 100 is inserted and the tobacco stick 100 having a high dielectric constant is present between the electrodes 305, 306, so the degree of polarization due to electrostatic induction is high, and the capacitance increases. For this reason, for example, the controller 37 can determine that the tobacco stick 100 is inserted when the detection value of the capacitance sensor 33 exceeds a predetermined threshold (first threshold), and can determine that the tobacco stick 100 is inserted when the detection value does not exceed the predetermined threshold.

As shown in Fig. 11, a capacitance detected varies depending on the locations P1 to P3 at which the electrodes 305, 306 are disposed with respect to the tobacco stick 100. This is presumably because, for example, the tobacco rod portion 110 disposed at the location P1 and the mouthpiece portion 120 disposed at the location P2 have different dielectric constants and, therefore, the degree of polarization due to electrostatic induction varies. For this reason, the controller 37 can determine the location of the tobacco stick 100 inserted in the container cavity 313 based on the detection value of the capacitance sensor 33. For example, the value (prescribed value) of capacitance of a state (prescribed state) where the tobacco stick 100 is inserted until the distal end 102 of the tobacco stick 100 contacts with the back wall 311 of the container 310 may be measured and stored in the memory 72 in advance, the controller 37 may determine that the location of the tobacco stick 100 has not reached the preset location when the detection value is less than the prescribed value and output a message or the like so that the tobacco stick 100 is inserted deeper.

Fig. 13 is a graph showing results obtained by detecting a capacitance while the sizes of the electrodes are varied. Fig. 13, as well as Fig. 11, shows results obtained by detecting a capacitance in a case where the tobacco stick 100 is not inserted between the electrodes 305, 306 and in a case where the electrodes 305, 306 are disposed at the locations P1 to P3 with respect to the tobacco stick 100. The bars B0-4, B1-4, B2-4, B3-4 are detection results of the electrodes 305, 306 of which the vertical and horizontal size is set to 4 mm by 4 mm. Similarly, the bars B0-6, B1-6, B2-6, B3-6 are detection results in a case where the electrode size is set to 6 mm by 6 mm, the bars B0-8, B1-8, B2-8, B3-8 are detection results in a case where the electrode size is set to 8 mm by 8 mm, and the bars B0-10, B1-10, B2-10, B3-10 are detection results in a case where the electrode size is set to 10 mm by 10 mm.

As shown in Fig. 13, when the electrode size is varied, the value of capacitance detected increases as the electrode size increases. This is presumably because, as the electrode size increases, a range in which electrostatic induction is influenced increases and, as a result, the amount of increase in electric charge in the electrodes 305, 306 increases. Even in a case where the electrode size is varied, when the tobacco stick 100 is inserted, the capacitance at any one of the locations P1 to P3 is greater than the capacitance in a state P0 where the tobacco stick 100 is not inserted as in the case of Fig. 11. The electrodes 305, 306 can detect the value of capacitance according to the locations P1 to P3 with respect to the tobacco stick 100. In this way, even when each of the electrodes 301, 302 of the capacitance sensor 33 is set to any size, the capacitance sensor 33 can detect the presence or absence and location of the tobacco stick 100. For this reason, for example, when the electrodes 305, 306 are set to be large, it is possible to obtain a stable detection result; whereas, when the electrodes 305, 306 are set to be small, it is possible to reduce the size of the non-combustion-type flavor inhaler 30.

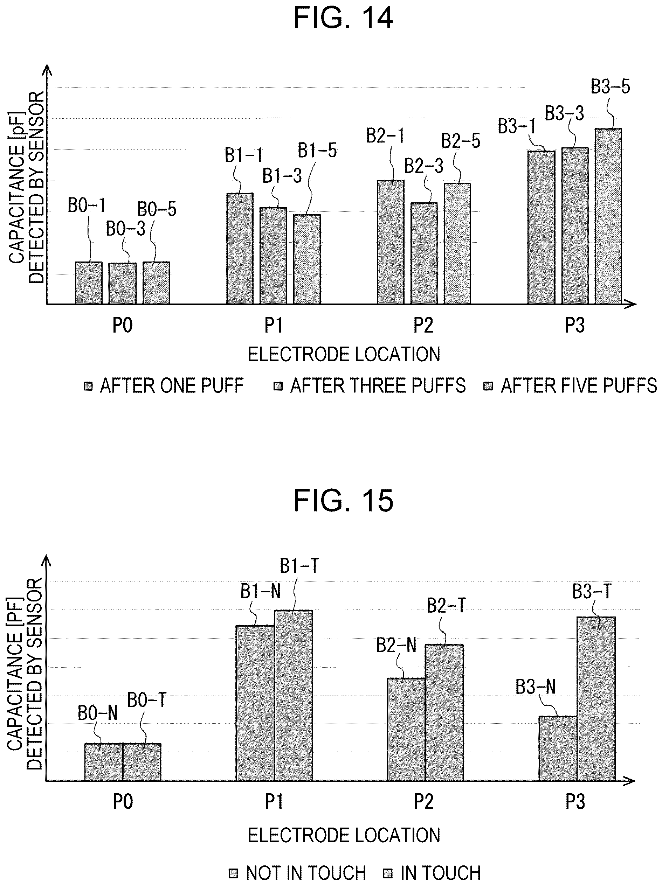

Fig. 14 is a graph showing a change in capacitance due to a puff. Fig. 14, as well as Fig. 11, shows results obtained by detecting a capacitance while the number of puffs is changed in a case where the tobacco stick 100 is not inserted between the electrodes 305, 306 and in a case where the location of the electrodes 305, 306 with respect to the tobacco stick 100 are varied.

The bars B0-1, B1-1, B2-1, B3-1 indicate the detection results after inhalation is performed once (hereinafter, also referred to as after one puff). Similarly, the bars B0-3, B1-3, B2-3, B3-3 indicate the detection results after three puffs, and the bars B0-5, B1-5, B2-5, B3-5 indicate the detection results after five puffs. The bars B0-1, B0-3, B0-5 are detection results obtained by performing detection in a state P0 where the tobacco stick 100 is not inserted between the electrodes 305, 306. The bars B1-1, B1-3, B1-5 are detection results of the electrodes 305, 306 disposed at the location P1. The bars B2-1, B2-3, B2-5 are detection results of the electrodes 305, 306 disposed at the location P2. The bars B3-1, B3-3, B3-5 are detection results of the electrodes 305, 306 disposed at the location P3.

As shown in Fig. 14, when detection is performed while the electrodes 305, 306 are disposed at the location P1, the capacitance decreases every time the number of puffs increases. This is presumably because the amount of moisture and the amount of flavor source, contained in the tobacco rod portion 110, decrease with inhalation. On the other hand, when the electrodes 305, 306 are disposed at the location P3, the capacitance increases every time the number of puffs increases. This is presumably because an aerosol component and the like that adhere to the mouthpiece portion 120 increases with inhalation. When the electrodes 305, 306 are disposed at the location P2, a change in capacitance due to an increase in the number of puffs is small, and there is no significant increasing or decreasing tendency. For this reason, the controller 37 can determine the number of puffs based on a detection value of the capacitance sensor 33 disposed on the outer peripheral side of the tobacco rod portion 110 or the outer peripheral side of the mouthpiece portion 120. In this way, when the amount of moisture or the amount of flavor source, contained in the tobacco stick 100, changes, a detection value of capacitance with the capacitance sensor 33 changes, so the controller 37 can determine the amount of moisture or the amount of flavor source in the tobacco stick 100 based on the detection value. For example, when the amount of moisture of the tobacco rod portion 110 is set to a known value, a capacitance is detected with the capacitance sensor 33, the amount of moisture is associated with the detection value of capacitance, a detection value of capacitance is further repeated while the amount of moisture is changed, and a detection value of capacitance, associated with each amount of moisture, is used as measuring data and stored in the memory 72. Thus, the controller 37 can detect the capacitance of the inserted tobacco rod portion 110 with the capacitance sensor 33 and obtain the amount of moisture associated with the detection value from the measuring data. Alternatively, measuring data can be generated by replacing the amount of moisture with the amount of flavor source or the amount of aerosol source, and the amount of flavor source or the amount of aerosol source can be obtained from a capacitance detection value. Furthermore, the amounts of moisture or the values of capacitance before inhalation of the tobacco stick 100 (unused state) set as a reference and after completion of inhalation (used state) may be detected in advance and stored in the memory 72 as reference data, and, when the tobacco stick 100 is inserted in the container cavity 313, the controller 37 may determine whether the inserted tobacco stick 100 has been used by comparing the amount of moisture or the value of capacitance of the inserted tobacco stick 100 with the reference data.

Fig. 15 is a graph showing a change in capacitance in a case where the hand of a user is touching the tobacco stick 100 and in a case where the hand is not touching the tobacco stick 100. In Fig. 15, as in the case of Fig. 11, detection is performed in a case where the tobacco stick 100 is not inserted between the electrodes 305, 306 and a case where the location of the electrodes 305, 306 with respect to the tobacco stick 100 is varied. The bars B0-N, B1-N, B2-N, B3-N are the ones obtained by performing detection in a state where the hand of the user is not touching the tobacco stick 100, and the bars B0-T, B1-T, B2-T, B3-T are the ones obtained by performing detection in a state where the hand of the user is touching the tobacco stick 100.

As shown in Fig. 15, when the hand of the user is touching the tobacco stick 100, the capacitance increases as compared to when the hand is not touching the tobacco stick 100. This is presumably because, when the hand of the user touches the tobacco stick 100, electric charge that moves from the tobacco stick 100 to the hand of the user increases. For this reason, the controller 37 can determine whether the hand of the user is touching the tobacco stick 100 based on a detection value of the capacitance sensor 33.

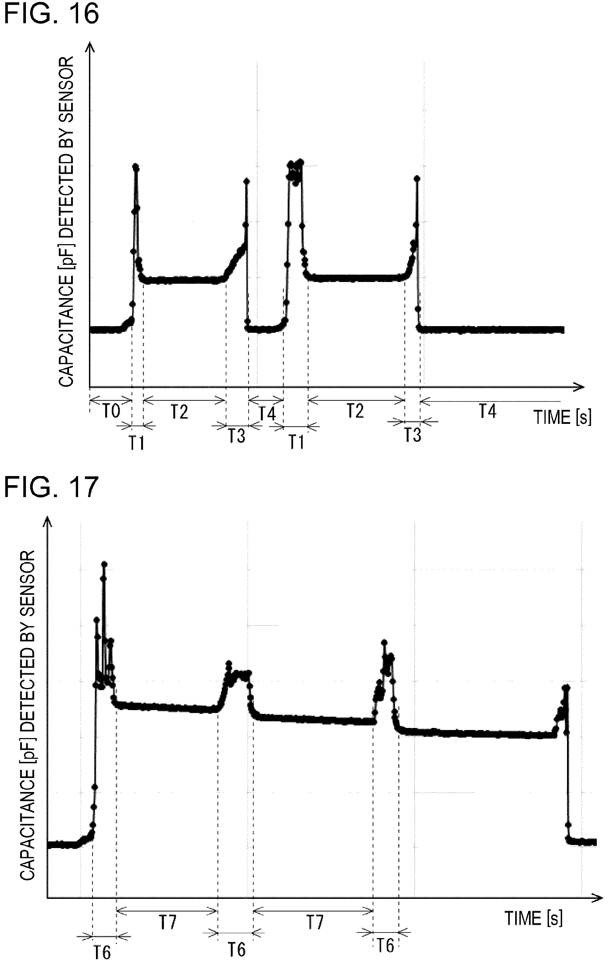

Fig. 16 is a graph showing a temporal change in capacitance at the time of inserting and removing the tobacco stick 100. In Fig. 16, T0 indicates timing (period) before the user holds the tobacco stick 100, T1 indicates timing when the user is inserting the tobacco stick 100 in his or her hand, T2 indicates timing when the user is releasing the hand from the tobacco stick 100 after insertion, T3 indicates timing when the user is removing the tobacco stick 100 in his or her hand, and T4 indicates timing when the tobacco stick 100 is removed and not inserted.

As shown in Fig. 16, when the tobacco stick 100 is inserted or removed in his or her hand, an increase and decrease in capacitance occur in a short period of time. This increase and decrease in capacitance in a short period of time occur in response to passage of the tobacco stick 100 through a sensor location and touching the tobacco stick 100 by the user. For this reason, for example, the controller 37 determines the period in which the capacitance steeply increases from a state where the tobacco stick 100 is not inserted (timing T0), subsequently the capacitance steeply decreases, and the decrease stops as the timing T1 when the user is inserting the tobacco stick 100 in his or her hand. The controller 37, for example, obtains the amount of change in detection value per unit time as a rate of change, determines that the user has started inserting the tobacco stick 100 in his or her hand when the rate of change at the time of an increase in the detection value exceeds a predetermined threshold (second threshold), subsequently determines that the user has finished inserting the tobacco stick 100 when the rate of change at the time of a reduction in detection value exceeds the second threshold and the rate of change does not exceed the second threshold in a state where the detection value is less than a predetermined value, and determines the period from the start of insertion of the tobacco stick 100 to the end of insertion as the timing T1.

The controller 37 determines the period after the timing T1 until the rate of change exceeds the second threshold next time as the timing T2. The controller 37 detects that the timing T0 is in a state where the tobacco stick 100 is not inserted and the timing T2 is in a state where the tobacco stick 100 is inserted, by comparing the detection values of capacitance at the timings T0, T2 with the first threshold. When the tobacco stick 100 is removed as well, the controller 37 determines the period when the rate of change at the time of increase in detection value exceeds the second threshold, subsequently the rate of change at the time of reduction in detection value exceeds the second threshold, and the rate of change does not exceed the second threshold in a state where the detection value is less than the predetermined value as the timing T3. The controller 37 determines the period after the timing T3 and the rate of change exceeds the second threshold next time as the timing T4. The controller 37 detects that the tobacco stick 100 is removed on condition that the detection value at the timing T4 does not exceed the first threshold.

Then, the controller 37 may use, for example, the value of capacitance detected at timing elapsed for a predetermined time (for example, one second) after switching from the timing T1 or T3 to the timing T2 or T4 to determine the state of the tobacco stick 100, such as the amount of moisture. Thus, the controller 37 can eliminate the influence in a case where the hand of the user touches the tobacco stick 100 and accurately detect the state of the tobacco stick 100.

At the time of puffing, when the user brings the mouth into contact with the mouthpiece portion 120, the capacitance increases. Fig. 17 is a graph showing a temporal change in capacitance at the time of bringing the mouth into contact with the mouthpiece portion 120 to inhale and separating the mouth from the mouthpiece portion 120 to blow out a breath. In Fig. 17, T6 indicates timing when the user is bringing the mouth into contact with the mouthpiece portion 120 of the tobacco stick 100, and T7 indicates timing when the user is separating the mouth from the mouthpiece portion 120.

As shown in Fig. 17, when the mouth is brought into contact with the mouthpiece portion 120, the capacitance steeply increases; when the mouth is separated, the capacitance steeply decreases. For this reason, for example, the controller 37 determines the period when the capacitance steeply increases from a state where the tobacco stick 100 is inserted and until the rate of change does not exceed a third threshold in a state where the detection value steeply reduces to below a predetermined value as the timing T6. The controller 37 determines the period after the timing T6 until the rate of change exceeds the third threshold next time as the timing T7.

The controller 37 may use the value of capacitance detected at timing elapsed for a predetermined time (for example, one second) after switching from the timing T6 to the timing T7 to determine the state of the tobacco stick 100, such as to determine the amount of moisture. Thus, the controller 37 can eliminate the influence in a case where the mouth of the user touches the tobacco stick 100 and accurately detect the state of the tobacco stick 100.

When the user touches the tobacco stick 100 with his or her hand or mouth, the capacitance changes. When the user touches the tobacco stick 100 with his or her hand or mouth and the capacitance changes as in the case of the timing T6, the controller 37 may determine the period as the timing T6 when inhalation is performed and determine the period as the timing when the user touches the tobacco stick 100 with his or her hand when inhalation is not performed, based on a detection result of the inhalation sensor 36.

As described above, since the capacitance detection value, detected with the capacitance sensor 33, changes depending on the state of the tobacco stick 100, the controller 37 may determine that the tobacco stick 100 is inserted, the tobacco stick 100 is already heated (used), the amount of moisture of the tobacco stick 100 has reached a prescribed value, the amount of aerosol source of the tobacco stick 100 has reached a prescribed value, or the amount of flavor source of the tobacco stick 100 has reached a prescribed value, when the detection value with the capacitance sensor 33 satisfies a predetermined condition.

The controller 37 determines the state of the tobacco stick 100 based on a first detection value detected by the capacitance sensor 33 at first timing after insertion of the tobacco stick 100 and a second detection value detected at second timing after the first timing. For example, the controller 37 determines that it is a state to end heating when the difference between the first detection value and the second detection value is greater than or equal to a first predetermined value.

Furthermore, the controller 37 determines that the amount of moisture, the amount of flavor source, or the like in the tobacco rod portion 110 has reduced and it is a state to change the heating temperature when the difference between the first detection value and the second detection value is greater than or equal to a second predetermined value.

[Control Method]

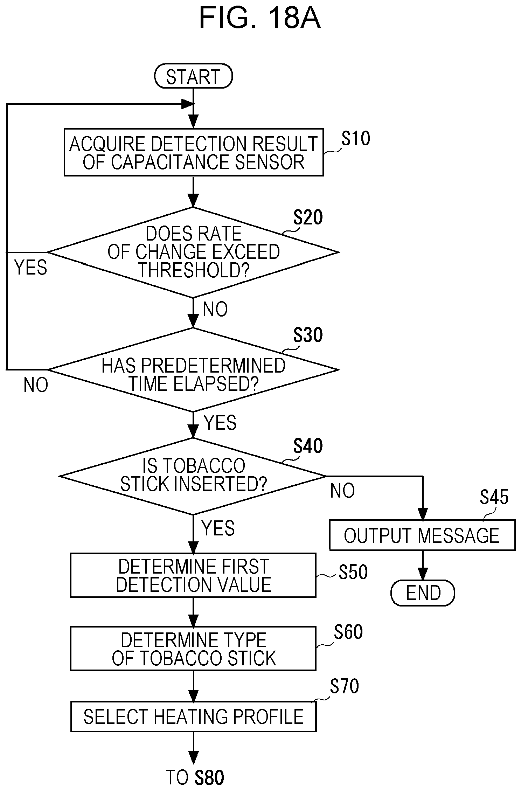

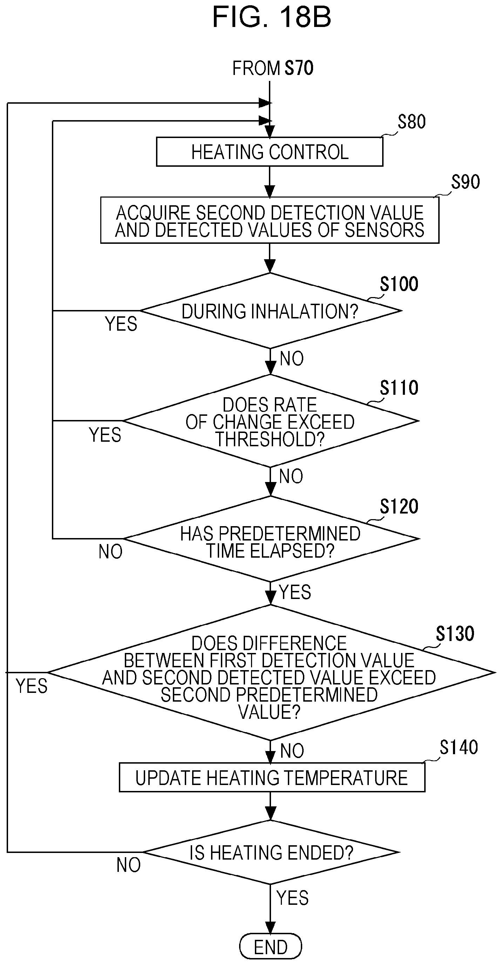

Fig. 18 is a flowchart showing a control method that the controller 37 executes. The controller 37 periodically executes the process of Fig. 18.

In step S10, the controller 37 acquires a detection value with the capacitance sensor 33. The controller 37 stores the acquired detection value in the memory 72.

In step S20, the controller 37 determines whether the rate of change in detection value of the capacitance sensor 33 exceeds the second threshold. As shown in Figs. 16 and 17, when the tobacco stick 100 is being inserted in his or her hand to insert the tobacco stick 100 into the container cavity 313 or when the mouth touches the tobacco stick 100 at the time of inhalation, the value of capacitance significantly changes, so it is difficult to use the state of the tobacco stick 100 for determination. For this reason, the controller 37 determines whether the detection value of the capacitance sensor 33 can be adopted, based on the rate of change. When the determination in step S20 is affirmative, the controller 37 returns to step S10 and repeats detection with the capacitance sensor 33 and determination on the rate of change. When the determination in step S20 is negative, the controller 37 proceeds to step S30.

In step S30, the controller 37 determines whether the detection value is a detection value after a lapse of a predetermined time from when the rate of change in detection value of the capacitance sensor 33 does not exceed the second threshold. Thus, the controller 37 determines that the detection value is stable, not the period during which the user is inserting the tobacco stick 100, or the like. When the determination in step S30 is negative, the controller 37 returns to step S10. When the determination is affirmative, the controller 37 proceeds to step S40.

In step S40, the controller 37 determines whether the tobacco stick 100 is inserted in the container cavity 313, based on the detection value of the capacitance sensor 33, acquired in step S10. The controller 37 makes negative determination (No in S40) when the detection value does not exceed the first threshold, proceeds to step S45 to output a message like "Tobacco Stick Is Not Inserted", and then ends the process of Figs. 18A and 18B. In step S40, the controller 37 may obtain the inserted location of the tobacco stick 100 based on the detection values and, when the location of the tobacco stick 100 has not reached a prescribed state, output a message prompting to set the tobacco stick 100 to the prescribed state like "Please Insert Tobacco Stick Deeper" in step S45.

On the other hand, the controller 37 makes affirmative determination that the tobacco stick 100 is inserted in the container cavity 313 (Yes in S40) when the detection value exceeds the first threshold in step S40, and proceeds to step S50. In step S50, the controller 37 determines the latest one of the detection value of the capacitance sensor 33, acquired in step S10, as a first detection value. The first detection value is the latest detection value at the time when it is determined that the tobacco stick 100 is inserted, and is the one detected at timing (first timing) just after the tobacco stick 100 is inserted and the tobacco stick 100 is not touched by the hand or the mouth.

In step S60, the controller 37 determines the type of the tobacco stick 100 based on the first detection value. For example, the controller 37 stores the value of capacitance corresponding to each type of the tobacco stick 100 in the memory 72 as a data table (type table) in advance and obtains the type of the tobacco stick 100 corresponding to the first detection value from the data table. The value of capacitance that applies to an already heated state may be registered in the data table. When the first detection value acquired in step S10 applies to the value of the already heated state (used state), the controller 37 may determine that the tobacco stick 100 is already heated and end the process of Figs. 18A and 18B.

In step S70, the controller 37 selects a heating profile based on the type of the tobacco stick 100, obtained in step S60. Here, a heating profile is, for example, setting data containing at least one of a heating temperature, a heating time, the number of times of inhalation, a heating temperature, a first predetermined value, and a second predetermined value. A heating profile desirably contains at least a heating temperature, a first predetermined value, and a second predetermined value.

In step S80, the controller 37 executes heating control based on the heating profile selected in step S70. The controller 37, for example, controls electric power supplied to the heater 32 such that the temperature of the heating region A1 becomes the heating temperature determined in the heating profile.

In step S90, the controller 37 acquires a capacitance detection value of the capacitance sensor 33 as a second detection value. The second detection value is a value detected in a step after step S10 in which a first detection value is acquired and is the one detected at timing (second timing) after the first timing. The first detection value is detected at the first timing before start of heating; whereas the second detection value is detected at the second timing after start of heating. The controller 37 acquires not only the second detection value with the capacitance sensor 33 but also detection values with the temperature sensor 35 and the inhalation sensor 36.

In step S100, the controller 37 determines whether inhalation is being performed, based on the detection value of the inhalation sensor 36. When the determination is affirmative in step S100, that is, inhalation is being performed, it is estimated that the mouth of the user is touching the mouthpiece portion 120, so the controller 37 returns to step S80 and repeats step S80 to step S100 until inhalation is not performed. Then, when the determination is negative in step S100, the controller 37 proceeds to step S110.

In step S110, the controller 37 determines whether the rate of change in second detection value exceeds the second threshold, that is, whether the hand or the like of the user is touching. A condition for determination is similar to that of step S20.

In step S120, the controller 37 determines whether the detection value is a detection value after a lapse of a predetermined time from when the rate of change in detection value of the capacitance sensor 33 does not exceed the second threshold. When the determination in step S120 is negative, the controller 37 returns to step S80. When the determination is affirmative, the controller 37 proceeds to step S130.

In step S130, the controller 37 compares the first detection value with the second detection value and determines whether the difference between the first detection value and the second detection value is greater than or equal to the second predetermined value. In other words, the controller 37 determines whether it is a state to change a heating temperature. In step S130, the controller 37 returns to step S80 when the determination is negative and proceeds to step S140 when the determination is affirmative. Step S130 is not an indispensable step, and step S130 may be omitted. When the heating profile does not contain a second predetermined value, the controller 37 may skip step S130 and proceed to step S150.

In step S140, the controller 37 updates a set value of heating temperature, that is, a target value of heating control with the heater 32, to a higher value to increase electric power supplied to the heater 32. Thus, even when the amount of flavor source and aerosol source is reducing, vaporization of flavor and generation of aerosol smoke are boosted. The controller 37 is not limited to changing the heating temperature to a higher value. The controller 37 may suppress vaporization of flavor and generation of aerosol smoke by changing the heating temperature to a lower value. Thus, it is possible to adjust satisfactory inhalation by changing the intensity of flavor or the amount of aerosol smoke according to the state of the tobacco stick 100.

In step S150, the controller 37 determines whether the difference between the first detection value and the second detection value is greater than or equal to the first predetermined value. In other words, the controller 37 determines whether it is a state to end heating. In step S150, the controller 37 returns to step S80 when the determination is negative, and, when the determination is affirmative, stops electric power supplied to the heater 32, cancels selection of the heating profi, and ends the process of Figs. 18A and 18B. The controller 37 may set a minimum time of heating or a minimum number of puffs, and, even when the difference between the first detection value and the second detection value is greater than or equal to the first predetermined value, may continue heating until the heating time exceeds the minimum time or the number of puffs exceeds the minimum number of times.

Step S60 and step S70 may be omitted, and a preset heating profile may be used.

[Advantageous Effects of Embodiment]

The non-combustion-type flavor inhaler 30 according to the present embodiment controls electric power supplied to the heater 32 based on a first detection value detected by the capacitance sensor 33 at first timing just after the tobacco stick 100 is inserted and a second detection value detected by the capacitance sensor 33 at second timing after the first timing. Thus, the non-combustion-type flavor inhaler 30 according to the present embodiment can accurately detect the state of the tobacco stick 100, which varies as a result of heating and puffing of the tobacco stick 100, and can appropriately execute heating control according to the state of the tobacco stick 100.

For example, the non-combustion-type flavor inhaler 30 increases electric power supplied to the heater 32 when the amount of flavor source or aerosol source reduces as a result of heating and puffing of the tobacco stick 100 and the difference between the first detection value and the second detection value is greater than or equal to the second predetermined value. Thus, even when the amount of flavor source or aerosol source reduces and the satisfactory inhalation is not achieved, the non-combustion-type flavor inhaler 30 can adjust the satisfactory inhalation by increasing the heating temperature and boosting vaporization of flavor and generation of aerosol smoke.

Furthermore, the non-combustion-type flavor inhaler 30 ends heating by stopping electric power supplied to the heater 32 when the difference between the first detection value and the second detection value is greater than or equal to the first predetermined value. Thus, when the amount of flavor source or aerosol source is almost depleted as a result of heating and puffing of the tobacco stick 100 and it is a state to end heating, the non-combustion-type flavor inhaler 30 can appropriately end the heating process.

The non-combustion-type flavor inhaler 30 includes the inhalation sensor 36 that detects that inhalation of the tobacco stick 100 is performed, and sets the timing to perform detection with the capacitance sensor 33 to the second timing in a period in which inhalation is not performed, based on a detection result of the inhalation sensor 36. Thus, it is possible to not adopt a detection value during inhalation as a second detection value, remove the influence at the time when the hand or the mouth is touching the tobacco stick 100, and accurately detect the state of the tobacco stick 100.

In the present embodiment, the capacitance sensor 33 has the first electrode 301 and the second electrode 302 disposed at a distance from each other, and the first electrode 301 and the second electrode 302 are disposed opposite to each other across the heating region A1. In other words, the first electrode 301 and the second electrode 302 are disposed such that, when the tobacco stick 100 is inserted in the container cavity 313, at least part of the tobacco rod portion 110 is inserted between the first electrode 301 and the second electrode 302. Thus, the non-combustion-type flavor inhaler 30 can accurately detect the state of the tobacco rod portion 110 and appropriately execute heating control.

<Second Embodiment>

In the above-described first embodiment, the first electrode 301 and the second electrode 302 of the capacitance sensor 33 are disposed across the heating regionAl. In a second embodiment, the first electrode 301 and the second electrode 302 are disposed across the non-heating region A2. The other configuration is the same as that of the above-described first embodiment, so like reference signs denote the same elements, and the description will not be repeated.

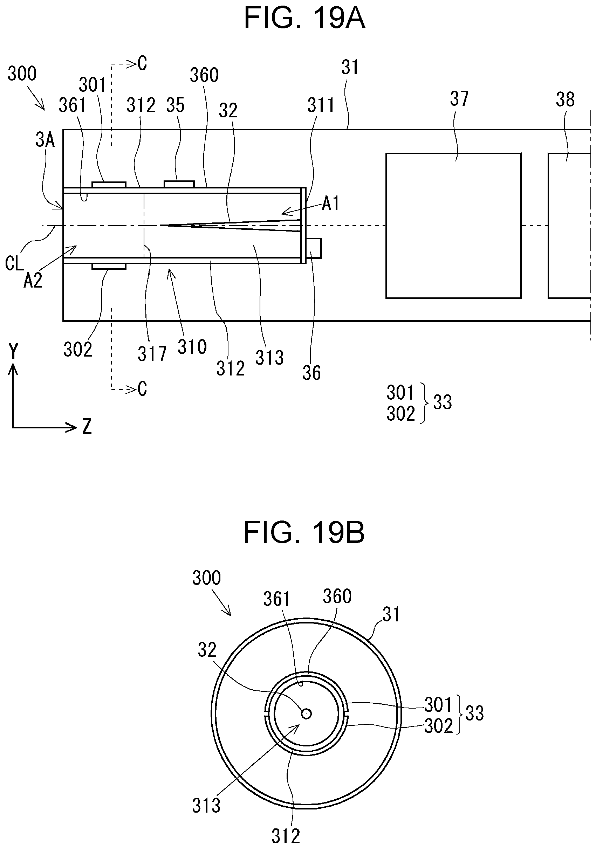

Fig. 19A is a schematic configuration diagram of a non-combustion-type flavor inhaler 300 according to the second embodiment. Fig. 19B is a sectional view taken along the line C-C in Fig. 19A. As shown in Figs. 19A and 19B, in the present embodiment, a first electrode and a second electrode are disposed opposite to each other across the non-heating region A2 on the outer periphery 360 of the circumferential wall 312 in the container 310. In other words, the first electrode 301 and the second electrode 302 are disposed such that, when the tobacco stick 100 is inserted in the container cavity 313, at least part of the mouthpiece portion 120 is inserted between the first electrode 301 and the second electrode 302.

When the capacitance is detected on the outer peripheral side of the mouthpiece portion 120 as shown in Fig. 14, the detection value increases as a result of puffing. This is presumably because moisture, flavor component, aerosol component, and the like sucked out from the tobacco rod portion 110 to the mouthpiece portion 120 side as a result of puffing adhere to inside the mouthpiece portion 120. Therefore, the controller 37 can determine the status of heating the tobacco stick 100 based on a change in the capacitance. The controller 37 according to the present embodiment compares a first detection value detected at first timing that is just after insertion of the tobacco stick 100 with a second detection value detected at second timing that is during heating, ends heating when the difference is greater than a first predetermined value, and changes the heating temperature when the difference is greater than a second predetermined value. This control procedure is the same as that of Figs. 18A and 18B described above.

In this way, since the first electrode 301 and the second electrode 302 of the capacitance sensor 33 are disposed on the outer peripheral side of the non-heating region A2, the non-combustion-type flavor inhaler 300 according to the present embodiment can accurately detect the state of the mouthpiece portion 120 and appropriately execute heating control.

<Third Embodiment>

In the above-described first embodiment, an example in which the conical heater 32 is provided at the center of the back wall 311 in the container 310 has been described, and a third embodiment differs from the first embodiment in a configuration including a cylindrical heater 32A. The other configuration is the same, so like reference signs denote the same elements, and the description will not be repeated.

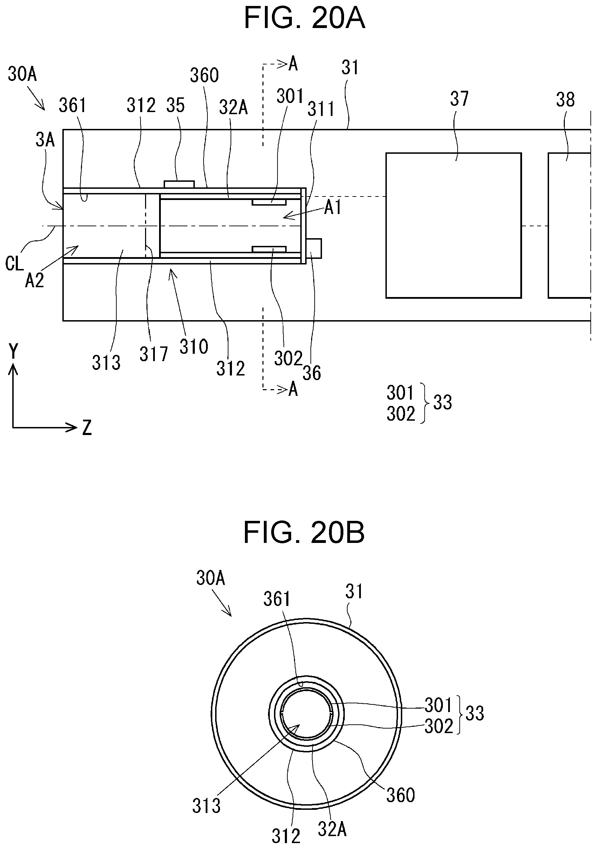

Fig. 20A is a schematic configuration diagram of a non-combustion-type flavor inhaler 30A according to the third embodiment. Fig. 20B is a sectional view taken along the line A-A in Fig. 20A. As shown in Figs. 20A and 20B, in the present embodiment, the cylindrical heater 32A is provided along the inner periphery 361 of the circumferential wall 312 in the container 310.

The electrodes 301, 302 of the capacitance sensor 33 are provided along the inner periphery of the heater 32A. In the present embodiment as well, the first electrode 301 and the second electrode 302 of the capacitance sensor 33 are disposed opposite to each other across the heating region A1. In other words, in the non-combustion-type flavor inhaler 30A according to the present embodiment, when the tobacco stick 100 is inserted in the container cavity 313, the tobacco rod portion 110 is configured to be located between the first electrode 301 and the second electrode 302.

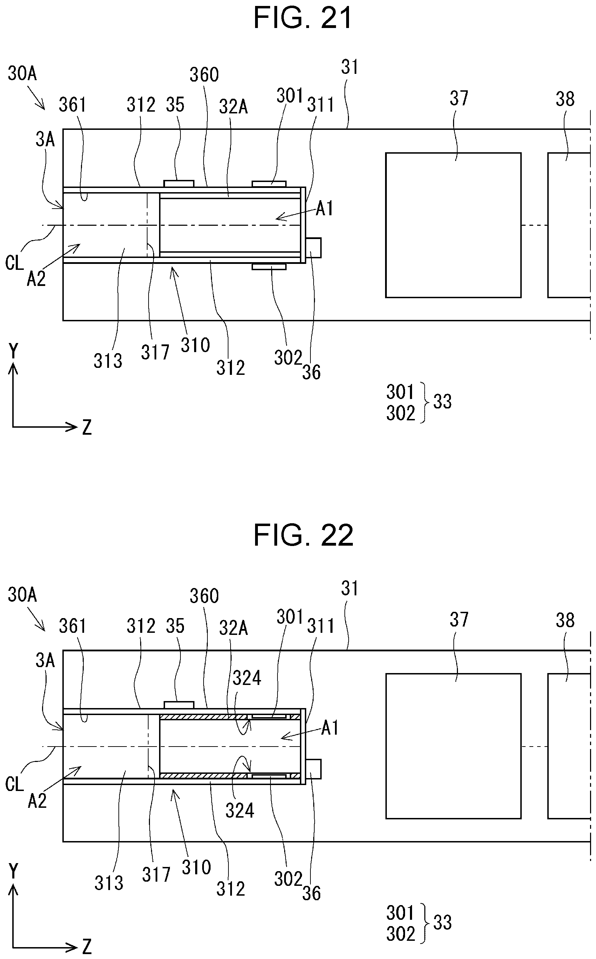

In Fig. 20A, the electrodes 301, 302 are provided on the inner peripheral side of the heater 32A; however, the configuration is not limited thereto. Fig. 21 shows an example in which the electrodes 301, 302 are provided along the outer periphery 360 of the circumferential wall 312 in the container 310. In this case, each of the electrodes 301, 302 may have a planar shape similarly to Fig. 5 or may be provided so as to be curved along a circumferential direction of the outer periphery 360 in the heater 32A similarly to Fig. 6. In the substantially cylindrical heater 32A, a part (hereinafter, also referred to as gap) where there is no circumferential wall of the heater 32A, such as a slit, a hole, and a notch, may be provided in part in the circumferential direction, and each of the electrodes 301, 302 may be disposed so as to be fitted to the gap. Fig. 22 shows an example in which hole-shaped gaps 324 are provided in the heater 32A and the electrodes 301, 302 are disposed so as to be respectively fitted to the hole-shaped gaps 324. In the examples of Figs. 20A to 22, the locations of the electrodes 301, 302 in the axial direction of the container 310 are the same as those of the above-described first embodiment.

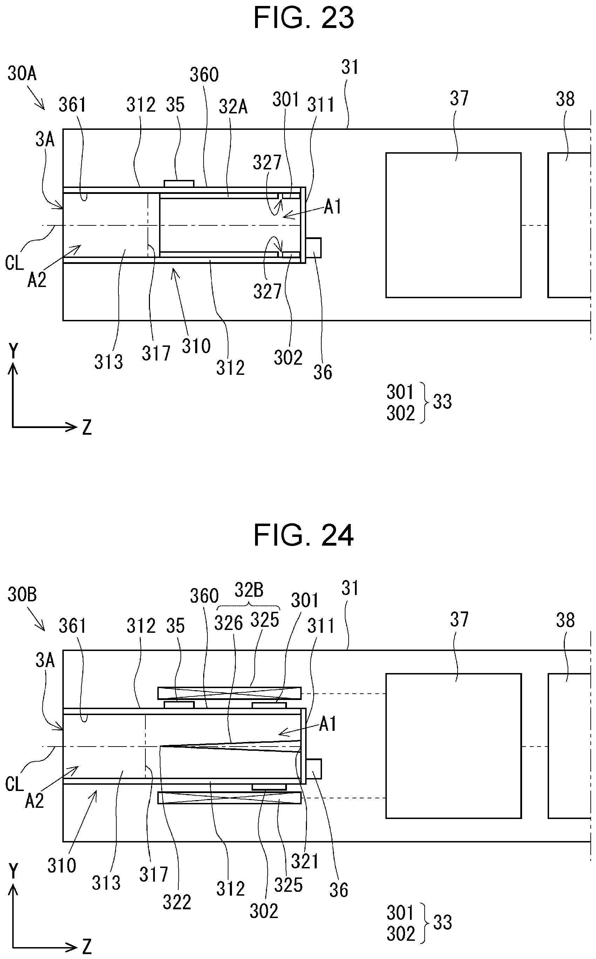

Fig. 23 is a view showing an example in which an installation location of the cylindrical heater 32A is offset to the front side in the axial direction of the container 310. In the above-described examples of Figs. 20A to 22, the heater 32A is disposed such that the back end is in contact with the back wall 311 of the container 310 and heats the tobacco stick 100 inserted in the container cavity 313 so as to be in contact with the back wall 311. However, the heater 32A does not heat only a portion in contact and also heats a portion away from the heater 32A by radiation and heat transfer, so, in the example of Fig. 23, the heater 32A is disposed at a clearance 327 from the back wall 311.

In this case, the distance between the back end of the heater 32A and the back wall 311 is determined so that the distal end 102 of the tobacco stick 100 in contact with the back wall 311 can be heated at a predetermined temperature. In other words, in the example of Fig. 23 as well, in the container cavity 313, a region from the back wall 311 to a portion (boundary 317) where the back end of the tobacco rod portion 110 or the distal end of the mouthpiece portion 120 is located is the heating region A1. In other words, the distal end to the back end of the tobacco rod portion 110 is configured to be disposed in the heating region A1.

In the example of Fig. 23, the electrodes 301, 302 of the capacitance sensor 33 are provided along the inner periphery 361 of the circumferential wall 312 in the clearance 327 between the heater 32A and the back wall 311. Thus, the capacitance sensor 33 can detect the capacitance without sandwiching the heater 32A between the first electrode 301 and the second electrode 302, so it is possible to accurately detect information on the tobacco stick 100.

The non-combustion-type flavor inhaler 30A according to the present embodiment, as in the case of the above-described first embodiment, detects at least the capacitance at the tobacco rod portion 110 with the capacitance sensor 33 and detects the state of the tobacco stick 100 based on the detection value, so it is possible to accurately execute heating control.

<Fourth Embodiment>

A fourth embodiment differs from the first embodiment in a configuration including an electromagnetic induction heating-type heater 32B. The other configuration is the same, so like reference signs denote the same elements, and the description will not be repeated.

Fig. 24 is a schematic configuration diagram of a non-combustion-type flavor inhaler 30B according to the fourth embodiment. The heater 32B includes an electromagnetic induction heating coil (induction coil) 325, and a heat generator 326 that generates heat through electromagnetic induction caused by the coil 325. The heat generator 326 is a substantially rod-shaped member formed long along the axial direction of the container cavity 313 and is a cone shape in the present embodiment. The heat generator 326 protrudes forward from the center of the back wall 311 along the axial direction in the container 310. The reference sign 321 indicates a proximal end of the heat generator 326. The reference sign 322 indicates a distal end of the heat generator 326. The heat generator 326 extends from the center of the circular back wall 311 toward the insertion port 3A and gradually tapers from the proximal end 321 toward the distal end 322. The shape of the heat generator 326 is not limited thereto. The shape of the heat generator 326 may be a rod shape with substantially the same diameter from the proximal end 321 to the distal end 322 or a planar shape (blade shape). The heat generator 326 may be made of a ferromagnetic metal, such as iron and iron alloys (stainless steel). When the tobacco stick 100 is inserted in the container cavity 313, the heat generator 326 is fitted into the tobacco rod portion 110 from the distal end 102 of the tobacco stick 100. The heat generator 326 may be not attached to the non-combustion-type flavor inhaler 30B but embedded in advance in the tobacco rod portion 110 of each tobacco stick 100.

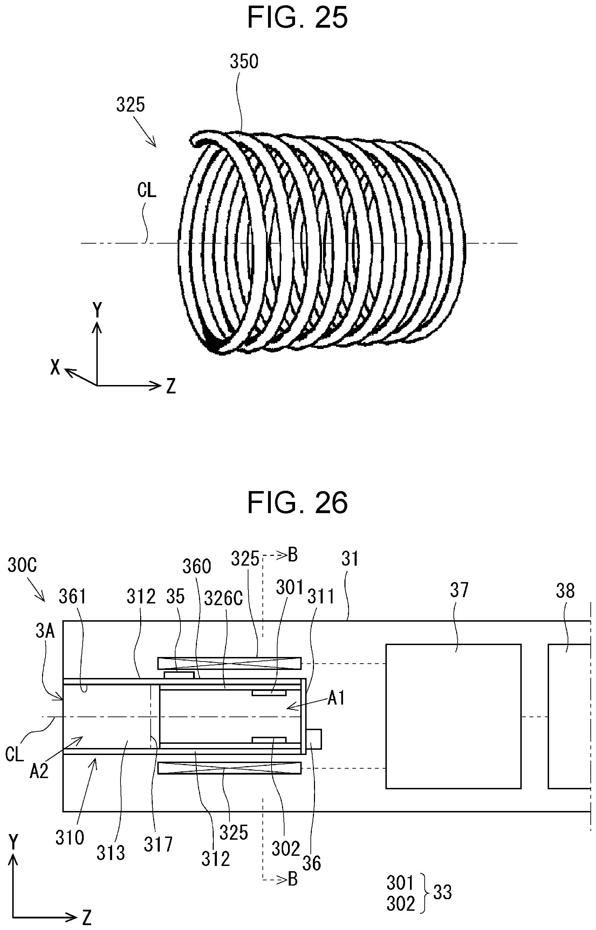

Fig. 25 is a perspective view of the coil 325. As shown in Fig. 25, the coil 325 is a cylindrical hollow coil, and a winding 350 is provided so as to be wound in the circumferential direction along the outer circumference of the circumferential wall 312 in the container 310.

The power supply (battery unit) 38 is a power supply that supplies electric power for heating to the coil 325 via the controller 37 and supplies DC current to the controller 37 in the present embodiment. In the present embodiment, the drive circuit 74 (Fig. 10) of the controller 37 includes a DC/AC inverter for supplying high-frequency AC current to the coil 325. When an operating switch is operated or when the controller 37 determines that the tobacco stick 100 is inserted in the container cavity 313, the controller 37 supplies AC current with a predetermined frequency to the coil 325 on the assumption that an instruction to start heating operation is issued. For example, the controller 37 may include a resonant capacitor and may be configured to supply AC current by resonating between the capacitor and the coil (inductor) 325. In this case, a frequency (resonant frequency) $f_0$ of AC current is determined as $f_0 = 1/(2\pi\sqrt{(LC)})$ with the capacitance C of the resonant capacitor and the inductance L of the coil 325.

The coil 325 supplied with AC current generates a varying electromagnetic field (alternating field) with the predetermined frequency. The frequency of the electromagnetic field is, for example, higher than or equal to 1 kHz and lower than or equal to 30 MHz, preferably higher than or equal to 50 kHz and lower than or equal to 500 kHz, and more preferably higher than or equal to 100 kHz and lower than or equal to 250 kHz. In the present embodiment, it is assumed that the inductance L of the coil is 1 $\mu$H and the frequency of the varying electromagnetic field is 200 kHz.

The varying electromagnetic field generates eddy current in the heat generator 326 disposed in the hollow part of the coil 325, that is, in the varying electromagnetic field, and causes the heat generator 326 to generate heat with this eddy current loss.

The controller 37 starts heating control on condition that, for example, the tobacco stick 100 is inserted or operation to start heating is performed, causes the heat generator 326 to generate heat by controlling electric power supplied to the coil 325, and causes the tobacco rod portion 110 to heat at a predetermined temperature. Here, in the container cavity 313, a space that is heated at a predetermined temperature with heat from the heat generator 326 is defined as heating region A1, and a space adjacent to the insertion port side of the heating regionAl in the axial direction (insertion and removal direction) is defined as non-heating region A2.

The electrodes 301, 302 of the capacitance sensor 33 are provided along the outer periphery 360 of the circumferential wall 312 in the container 310. In the present embodiment as well, the first electrode 301 and the second electrode 302 of the capacitance sensor 33 are disposed opposite to each other across the heating region A1. For this reason, as in the case of the first embodiment, the capacitance sensor 33 can detect the state of the tobacco stick 100. Heating control or the like based on the detection result of the capacitance sensor 33 is also the same as that of the above-described first embodiment.

In this way, the non-combustion-type flavor inhaler 30B according to the present embodiment, which heats the tobacco stick 100 in an electromagnetic induction heating system, as well, as in the case of the above-described first embodiment, detects at least the first detection value and the second detection value at the tobacco rod portion 110 with the capacitance sensor 33, and accurately detects the state of the tobacco stick 100 based on these detection values, so it is possible to appropriately execute heating control.

<Fifth Embodiment>

In the above-described fourth embodiment, an example in which the conical heat generator 326 is provided at the center of the back wall 311 in the container 310 has been described, and a fifth embodiment differs from the fourth embodiment in a configuration including a cylindrical heat generator 326C. The other configuration is the same, so like reference signs denote the same elements, and the description will not be repeated.

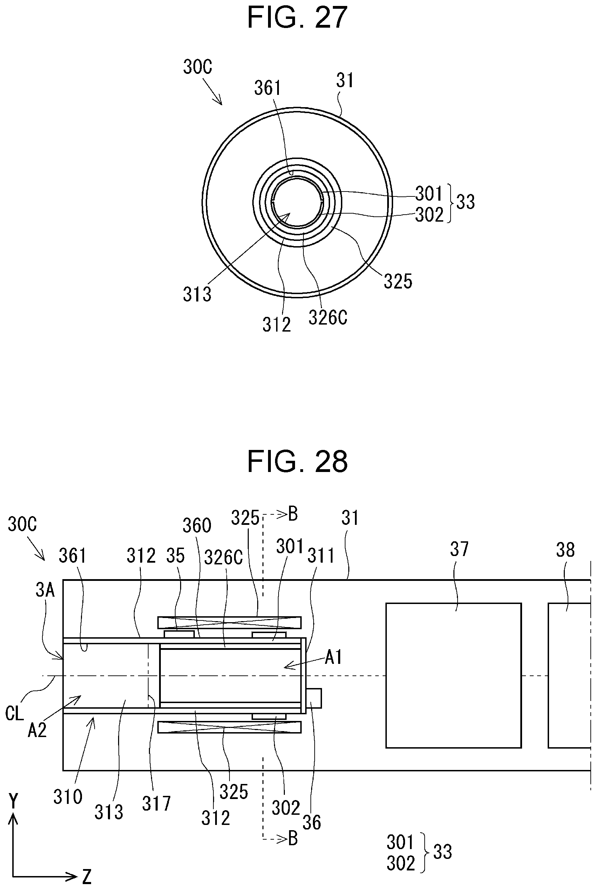

Fig. 26 is a schematic configuration diagram of a non-combustion-type flavor inhaler 30C according to the fifth embodiment. Fig. 27 is a sectional view taken along the line B-B in Fig. 26. As shown in Figs. 26 and 27, in the present embodiment, the cylindrical heat generator 326C is provided along the inner periphery of the circumferential wall 312 in the container 310.

The electrodes 301, 302 of the capacitance sensor 33 are provided along the inner periphery of the heat generator 326C. In the present embodiment as well, the first electrode 301 and the second electrode 302 of the capacitance sensor 33 are disposed opposite to each other across the heating region A1.

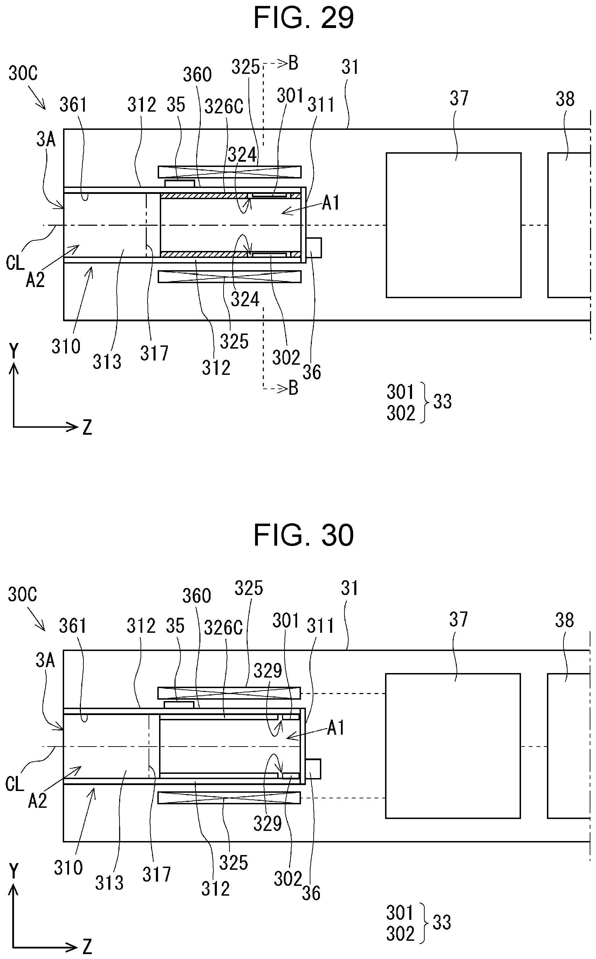

In Fig. 26, the electrodes 301, 302 are provided on the inner peripheral side of the heat generator 326C; however, the configuration is not limited thereto. Fig. 28 shows an example in which the electrodes 301, 302 are provided on the outer peripheral side of the heat generator 326C. In this case, each of the electrodes 301, 302 may have a planar shape similarly to Fig. 5 or may be provided so as to be curved along a circumferential direction of the outer periphery 363 in the heat generator 326C similarly to Fig. 6. In the substantially cylindrical heat generator 326C, a part (hereinafter, also referred to as gap) where there is no circumferential wall of the heat generator 326C, such as a slit, a hole, and a notch, may be provided in part in the circumferential direction, and each of the electrodes 301, 302 may be disposed so as to be fitted to the gap. Fig. 29 shows an example in which hole-shaped gaps 324 are provided in the heat generator 326C and the electrodes 301, 302 are disposed so as to be respectively fitted to the hole-shaped gaps 324. The locations of the electrodes 301, 302 in the axial direction of the container 310 are the same as those of the above-described fourth embodiment.

Fig. 30 is a view showing an example in which an installation location of the cylindrical heat generator 326C is offset to the front side in the axial direction of the container 310. In the examples of Figs. 26 to 29, the heat generator 326C is disposed such that the back end is in contact with the back wall 311 of the container 310 and heats the tobacco stick 100 inserted in the container cavity 313 so as to be in contact with the back wall 311. However, the heat generator 326C does not heat only a portion in contact and also heats a portion away from the heat generator 326C by radiation and heat transfer, so, in the example of Fig. 30, the heat generator 326C is disposed with a clearance 329 from the back wall 311.

In this case, the distance between the back end of the heat generator 326C and the back wall 311 is determined so that the distal end 102 of the tobacco stick 100 in contact with the back wall 311 can be heated at a predetermined temperature. In other words, in the example of Fig. 30 as well, in the container cavity 313, a region from the back wall 311 to a portion (boundary 317) where the back end of the tobacco rod portion 110 or the distal end of the mouthpiece portion 120 is located is the heating regionAl. In other words, the distal end to the back end of the tobacco rod portion 110 is configured to be disposed in the heating region A1.

In the example of Fig. 30, the electrodes 301, 302 of the capacitance sensor 33 are provided along the inner periphery 361 of the circumferential wall 312 in the clearance 329 between the heat generator 326C and the back wall 311. Thus, the capacitance sensor 33 can detect the capacitance without sandwiching the heat generator 326C between the first electrode 301 and the second electrode 302, so it is possible to accurately detect information on the tobacco stick 100.

The non-combustion-type flavor inhaler 30C according to the present embodiment, as in the case of the above-described fourth embodiment, detects at least the first detection value and the second detection value at the tobacco rod portion 110 with the capacitance sensor 33, and accurately detects the state of the tobacco stick 100 based on these detection values, so it is possible to appropriately execute heating control.

<Sixth Embodiment>

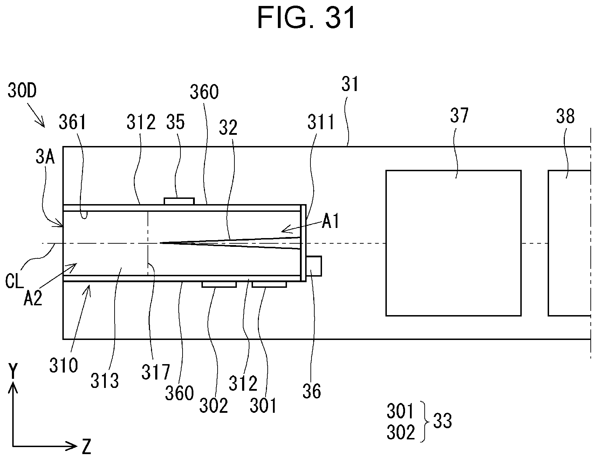

Fig. 31 is a schematic configuration diagram of a non-combustion-type flavor inhaler 30D according to a sixth embodiment. The present embodiment differs from the above-described first embodiment in a configuration in which the electrodes 301, 302 of the capacitance sensor 33 are disposed so as to be arranged in the axial direction of the container 310. The other configuration is the same, so like reference signs denote the same elements, and the description will not be repeated.

As shown in Fig. 31, in the present embodiment, the electrodes 301, 302 of the capacitance sensor 33 are arranged along the axial direction of the container 310 on the outer periphery 360 of the circumferential wall 312. The first electrode 301 and the second electrode 302 are disposed on the outer peripheral side of the heating region A1. In other words, the first electrode 301 and the second electrode 302 are provided at locations close to the tobacco rod portion 110 when the tobacco stick 100 is inserted in the container cavity 313. For this reason, the capacitance sensor 33 detects the capacitance of the tobacco rod portion 110 in the inserted tobacco stick 100.

The non-combustion-type flavor inhaler 30D according to the present embodiment, as in the case of the above-described first embodiment, detects at least the first detection value and the second detection value at the tobacco rod portion 110 with the capacitance sensor 33, and accurately detects the state of the tobacco stick 100 based on these detection values, so it is possible to appropriately execute heating control.

Reference Signs List

| | |
|---|---|
| 100 | tobacco stick |
| 101 | mouthpiece end |
| 102 | distal end |
| 103 | air hole |
| 110 | tobacco rod portion |
| 111 | filler |
| 112 | wrapping paper |
| 120 | mouthpiece portion |
| 121 | cooling segment |
| 122 | filter segment |
| 130 | tipping paper |
| 200 | non-combustion-type flavor inhaling system |
| 30, 30A, 30B, 30C, 30D | non-combustion-type flavor inhaler |
| 301 | first electrode |
| 302 | second electrode |
| 305, 306 | electrode |
| 307, 308 | wiring line |
| 31 | housing |
| 310 | container |
| 311 | back wall |
| 312 | circumferential wall |
| 313 | container cavity |
| 32, 32A | heater |
| 321 | proximal end |
| 322 | distal end |
| 324 | gap |
| 325 | coil |
| 326, 326C | heat generator |
| 32B | heater |
| 33 | capacitance sensor |
| 330 | flexible circuit board |
| 331 | first strip portion |
| 333 | second strip portion |
| 334 | end |
| 35 | temperature sensor |
| 350 | winding |
| 36 | inhalation sensor |
| 37 | controller |
| 38 | power supply (battery unit) |
| 3A | insertion port |
| 71 | processor |
| 711 | determiner |
| 712 | heat controller |
| 713 | output controller |
| 72 | memory |
| 73 | input/output portion |
| 74 | drive circuit |

**Claims**

1. A non-combustion-type flavor inhaler comprising:

   a container that accommodates a flavor stick having a flavor rod portion and an inhalation port so that the flavor stick can be inserted and removed;
   a controller that controls heating with the heater by controlling electric power supplied to a heater for heating the flavor stick; and
   a capacitance sensor that detects a capacitance that changes depending on a state of the flavor stick accommodated in the container, wherein
   the controller controls electric power supplied to the heater based on a first detection value detected by the capacitance sensor at first timing after insertion of the flavor stick and a second detection value detected at second timing after the first timing.

2. The non-combustion-type flavor inhaler according to claim 1, wherein the controller ends heating when a difference between the first detection value and the second detection value is greater than or equal to a first predetermined value.

3. The non-combustion-type flavor inhaler according to claim 1 or 2, wherein the controller changes electric power supplied to the heater when a difference between the first detection value and the second detection value is greater than or equal to a second predetermined value.

4. The non-combustion-type flavor inhaler according to claim 1, wherein
   the controller

   ends heating when a difference between the first detection value and the second detection value is greater than or equal to a first predetermined value, and
   changes electric power supplied to the heater when a difference between the first detection value and the second detection value is greater than or equal to a second predetermined value lower than the first predetermined value.

5. The non-combustion-type flavor inhaler according to any one of claims 1 to 4, wherein the first timing is timing determined to a period from just after insertion of the flavor stick to just before start of heating.

6. The non-combustion-type flavor inhaler according to any one of claims 1 to 5, further comprising

   an inhalation sensor that detects that inhalation of the flavor stick is performed, wherein
   the controller sets the second timing to timing to perform detection with the capacitance sensor in a period in which inhalation is not being performed, based on a detection result of the inhalation sensor.

7. The non-combustion-type flavor inhaler according to any one of claims 1 to 6, wherein

   the capacitance sensor has a first electrode and a second electrode disposed at a distance from each other and detects a capacitance between the first electrode and the second electrode, and
   the first electrode and the second electrode are disposed across a space in which the flavor rod portion is accommodated such that, when the flavor stick is accommodated in the container, at least part of the flavor rod portion is inserted between the first electrode and the second electrode.

8. The non-combustion-type flavor inhaler according to any one of claims 1 to 7, wherein

   the capacitance sensor has a first electrode and a second electrode disposed at a distance from each other and detects a capacitance between the first electrode and the second electrode, and
   the first electrode and the second electrode are disposed across a space in which the inhalation port is accommodated such that, when the flavor stick is accommodated in the container, at least part of the inhalation port is inserted between the first electrode and the second electrode.

# FIG. 1

# FIG. 2

## FIG. 3

## FIG. 4

# FIG. 5

# FIG. 6

# FIG. 7

# FIG. 8

## FIG. 9

## FIG. 10

FIG. 11

FIG. 12

FIG. 13

4 mm x 4 mm    6 mm x 6 mm    8 mm x 8 mm    10 mm x 10 mm

## FIG. 14

CAPACITANCE [pF] DETECTED BY SENSOR

ELECTRODE LOCATION

□ AFTER ONE PUFF    □ AFTER THREE PUFFS    □ AFTER FIVE PUFFS

## FIG. 15

CAPACITANCE [PF] DETECTED BY SENSOR

ELECTRODE LOCATION

□ NOT IN TOUCH    □ IN TOUCH

## FIG. 16

## FIG. 17

# FIG. 18A

START

ACQUIRE DETECTION RESULT
OF CAPACITANCE SENSOR ⟋S10

DOES RATE
OF CHANGE EXCEED
THRESHOLD? ⟋S20

YES

NO

HAS PREDETERMINED
TIME ELAPSED? ⟋S30

NO

YES

IS TOBACCO
STICK INSERTED? ⟋S40

NO

OUTPUT MESSAGE ⟋S45

END

YES

DETERMINE FIRST
DETECTION VALUE ⟋S50

DETERMINE TYPE
OF TOBACCO STICK ⟋S60

SELECT HEATING PROFILE ⟋S70

TO S80

# FIG. 18B

FROM S70

HEATING CONTROL — S80

ACQUIRE SECOND DETECTION VALUE AND DETECTED VALUES OF SENSORS — S90

DURING INHALATION? — S100
YES

NO

DOES RATE OF CHANGE EXCEED THRESHOLD? — S110
YES

NO

HAS PREDETERMINED TIME ELAPSED? — S120
NO

YES

DOES DIFFERENCE BETWEEN FIRST DETECTION VALUE AND SECOND DETECTED VALUE EXCEED SECOND PREDETERMINED VALUE? — S130
YES

NO

UPDATE HEATING TEMPERATURE — S140

IS HEATING ENDED?
NO

YES

END

# FIG. 19A

# FIG. 19B

# FIG. 20A

# FIG. 20B

# FIG. 21

# FIG. 22

# FIG. 23

# FIG. 24

# FIG. 25

350

325

CL

Y

X

Z

# FIG. 26

30C

361 312 35 360 326C 301 311 31 37 38

3A

CL

A2

310 313 317 312 302 36

301
302 } 33

Y

Z

# FIG. 27

# FIG. 28

# FIG. 29

# FIG. 30

# FIG. 31

## INTERNATIONAL SEARCH REPORT

International application No.

**PCT/JP2022/047579**

### A. CLASSIFICATION OF SUBJECT MATTER

*A24F 40/20*(2020.01)i; *A24F 40/40*(2020.01)i; *A24F 40/50*(2020.01)i
FI:   A24F40/50; A24F40/40; A24F40/20

According to International Patent Classification (IPC) or to both national classification and IPC

### B. FIELDS SEARCHED

Minimum documentation searched (classification system followed by classification symbols)

A24F40/20; A24F40/40; A24F40/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2020/165450 A1 (PHILIP MORRIS PRODUCTS S.A.) 20 August 2020 (2020-08-20) specification, p. 4, line 32 to p. 13, line 18, p. 26, line 3 to p. 33, line 22, fig. 1-12 | 1-5 |
| Y | | 7-8 |
| A | | 6 |
| Y | JP 2021-519097 A (NICOVENTURES TRADING LIMITED) 10 August 2021 (2021-08-10) paragraphs [0034]-[0035], fig. 1-9 | 7-8 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 February 2023** | **21 February 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/047579**

| Patent document cited in search report | | | Publication date (day/month/year) | Patent family member(s) | | | Publication date (day/month/year) |
|---|---|---|---|---|---|---|---|
| WO | 2020/165450 | A1 | 20 August 2020 | CN | 113382646 | A | |
| | | | | EP | 3923754 | A1 | |
| | | | | JP | 2022-520171 | A | |
| | | | | KR | 10-2021-0126582 | A | |
| | | | | US | 2022/0125110 | A1 | |
| JP | 2021-519097 | A | 10 August 2021 | US | 2021/0007401 | A1 | |
| | | | | paragraphs [0041]-[0042], fig. 1-9 | | | |
| | | | | AU | 2019241460 | A1 | |
| | | | | BR | 112020020004 | A2 | |
| | | | | CA | 3095452 | A1 | |
| | | | | CN | 111918568 | A | |
| | | | | EP | 3773028 | A1 | |
| | | | | IL | 277486 | A | |
| | | | | KR | 10-2020-0123240 | A | |
| | | | | RU | 2762357 | C1 | |
| | | | | WO | 2019/185744 | A1 | |

Form PCT/ISA/210 (patent family annex) (January 2015)

**REFERENCES CITED IN THE DESCRIPTION**

**Patent documents cited in the description**

- JP 2017510270 W
- JP 2019185748 A

- JP 2017218699 A

**Non-patent literature cited in the description**

- Tobacco Dictionary. Tobacco Research Center, 31 March 2009